# EUROPEAN PATENT APPLICATION

(11) **EP 4 270 504 A1**
(43) Date of publication of application: **01.11.2023**
(21) Application number: 22170076.8
(22) Date of filing: 26.04.2022
(51) Int. Cl.: H01L 39/22, H01L 39/24

(54) **CONTACT LAYER FOR LAYERED MATERIALS**

(71) Applicant: Terra Quantum AG, 9400 Rorschach (CH)
(72) Inventor: SAGGAU, Christian, 9400 Rorschach (CH); SHOKRI, Sanaz, 9400 Rorschach (CH); MARTINI, Mickey, 9400 Rorschach (CH); LEE, Yejin, 9400 Rorschach (CH); NIELSCH, Kornelius, 9400 Rorschach (CH); VINOKOUR, Valerii, 9400 Rorschach (CH); POCCIA, Nicola, 9400 Rorschach (CH)
(74) Representative: Kretschmann, Dennis

(57) **Abstract**

An electronics device comprises a substrate (100), a first layer (102a) of a first layered material arranged over the substrate, a second layer of a second layered material arranged over the substrate, an overlap region, and a contact layer (104). In the overlap region, the second layer is arranged over the first layer, and a section of a bottom surface of the second layer is parallel to a section of a top surface of the first layer. The contact layer is arranged over the first layer and the second layer. The contact layer comprises a plurality of electrically conductive lines and an electrical insulation element. The plurality of electrically conductive lines (108, 108a) comprises a first electrically conductive line and a second electrically conductive line. The first electrically conductive line and/or the second electrically conductive line comprises a superconductor material. The electrical insulation element (114) is arranged between the electrically conductive lines to electrically insulate them from each other. The electronics device further comprises a first electrical contact between the first electrically conductive line and the first layer; and a second electrical contact between the second electrically conductive line and the second layer. A method for manufacturing the electronics device is also disclosed.

## Description

### TECHNICAL FIELD

The disclosure relates to an electronics device, such as a Josephson junction device, wherein a layered material, such as a van der Waals material and/or a 2D material, is electrically contacted with electrically conductive lines, in particular with superconducting lines.

### BACKGROUND

Layered materials and two-dimensional (2D) materials derived therefrom, such as graphene, MoS2, h-BN triggered a new field of physical research. Recent developments are dedicated to the physics associated with devices made from stacked layers of layered materials and/or 2D materials. Corresponding devices are also known as van der Waals (VdW) heterostructures.

Graphite and graphene, which are the prototypical layered and 2D materials, are mostly chemically inert. Other layered materials and their 2D counterparts, composed, for example, of MeTe2, NbSe2 or (layered or 2D) high temperature superconductors are prone to damage due to environmental exposure to oxygen and moisture.

Further damage can occur during electrically contacting the layered or 2D material, for example in a metallization step. In particular, high energy atoms colliding with the atomic layer tend to create defects that lead to Fermi level pining, among other flaws. Also, thermal/infrared radiation from a crucible, comprising the metallic material to be deposited onto the layered or 2D material for metallization, may heat the layered or 2D material to an exceedingly high temperature. At such high temperature, chemical decomposition of the layered or 2D material may occur.

A scalable approach requires the integration of the layered material with electrical circuits, i. e. electrically contacting the layered or 2D material, without degrading its physical properties.

For this purpose, different approaches have been suggested. Examples include inkjet printing of contacts, as well as the transfer of electric via contacts etched into h-BN membranes, see E. J. Telford et al., "Via Method for Lithography Free Contact and Preservation of 2D Materials", Nano Lett. 2018, 18, 1416. In the latter approach, the membranes with the via contacts are then transferred by contact printing. Both methods have their own disadvantages - inkjet printing is typically limited to resolutions of tens of microns and printed conductors show a degraded electrical performance in comparison to PVD or CVD deposited ones. Transferred via contacts in the h-BN are limited in size (flake size are typically about tens of microns) and require a very exact alignment between the via contacts and electron beam lithography (EBL) written or stencil mask deposited circuits. Further the deposition might still degrade the 2D material because of the transfer of heat. Furthermore, material incorporation into the h-BN can degrade its insulating properties. Additionally, this approach is typically limited to noble metals as they are easily delaminated from a host substrate.

WO 2019/183105 A1 discloses a van der Waals integration approach for material integration and device fabrication.

KR 2003-0071306 A discloses a manufacturing method for a Josephson junction device.

### OVERVIEW

In view of the technical problems laid out above, there is a need for an electronics device with improved electrical contacts to a layered material, such as a van der Waals material and/or a 2D material, or a stack of layers of such materials.

This objective is achieved with an electronics device according to claim 1. Claim 14 provides a method for fabricating an electronics device. The dependent claims relate to preferred embodiments.

According to a first aspect, an electronics device comprises a substrate, a first layer of a first layered material arranged over the substrate, a second layer of a second layered material arranged over the substrate, an overlap region, and a contact layer. In the overlap region, the second layer is arranged over the first layer, and a section of a bottom surface of the second layer is parallel to a section of a top surface of the first layer. The contact layer is arranged over the first layer and the second layer. The contact layer comprises a plurality of electrically conductive lines and an electrical insulation element. The plurality of electrically conductive lines comprises a first electrically conductive line and a second electrically conductive line. The first electrically conductive line or the second electrically conductive line comprises a superconductor material. The electrical insulation element is arranged between the electrically conductive lines to electrically insulate them from each other. The electronics device further comprises a first electrical contact between the first electrically conductive line and the first layer; and a second electrical contact between the second electrically conductive line and the second layer.

To solve at least some of the problems mentioned above, a contact layer is provided with an insulating layer and electrical contacts arranged therein. The contact layer may be formed on a separate substrate. Subsequently, the contact layer is released from the substrate and transfer printed onto the layered material.

This approach avoids damage to a layered material, such as a van der Waals material and/or a 2D material, due to electrical contacts. Moreover, it flexibly permits a large variety of electrically conductive materials, including superconducting materials (i. e., material adapted to exhibit superconductivity when its temperature is below its respective critical temperature), to be used in electrically conductive lines providing the electrical contact. This is an advantage over pre-existing techniques, which are limited to noble metals for electrical contacting, in particular in the context of layered HTS devices, such as Josephson junction devices. In such devices, the superconducting properties of the HTS make electrical contacts to electrically conductive lines particularly desirable, which provide superconducting properties as well.

For example, the layered high temperature superconductors (HTS) like Bi₂Sr₂Caₙ₋₁CuₙO₂ₙ₊₄ with n = 0, 1, 2, 3 (BSCCO) form a promising system for high-quality qubits. In such HTS, c-axis tunneling may be implemented, which provides an improved tolerance towards stray magnetic fields and a higher operating temperature. The use of such HTS may overall lead to an increase of the coherence time of a prospective qubit based thereon. Furthermore, a stack of layers of such layered HTS (HTS VdW heterostructure) can be arranged with a twist of the layers of the stack (i. e., their respective lattice vectors parallel to their respective crystallographic layers) with respect to each other around an axis perpendicular to the stack. The arrangement with the twist improves the suppression of detrimental aspects d-wave pairing.

Problems related to the implementation of Josephson junctions comprising BSCCO may be associated with a change of an oxygen content and/or of the parameter "n" of the BSCCO at the surface. For example, these conventional fabrication techniques may apply elevated temperatures exceeding room temperature, in particular during a metallization step. The fabrication method and the electronics device according to the disclosure avoid the changes, and help to successfully implement a high-temperature superconducting qubit.

However, BSCCO is to be taken merely as an example. The sensitivity to damage during electrical contacting is not unique to BSCCO, but a larger variety of layered material, for example transition metal dichalcogenides, pose similar problems. The contact layer according to the description may improve an electronic device comprising electrical contacts to any of those layered materials.

In the context of the present disclosure, the section of the top surface and the section of the bottom surface may be understood to overlap if a line perpendicular to the section of the top surface and/or to the section of the bottom surface exists such that the line intersects both the section of the top surface and the section of the bottom surface.

The first electrically conductive line may extend through the electrical insulation element away from the first electrical contact.

The second electrically conductive line may extend through the electrical insulation element away from the second electrical contact.

The first (second) electrically conductive line and/or the first (second) electrical contact may extend below the electrical insulation element, for example between the electrical insulation element and the first (second) layer.

The electronics device may comprise a first gap between the contact layer and the first layer and/or the second layer. The first gap may extend along at least a section of a boundary of the overlap region.

Generating the first gap may go hand in hand with the transfer technique according to the disclosure, resulting in the improved electrical contacting.

The electronics device may comprise a second gap between the contact layer and the first layer and/or the substrate, for example along at least a section of a boundary of the first layer.

The electronics device may comprise a third gap between the contact layer and the second layer and/or the substrate, for example along at least a section of a boundary of the second layer.

The second gap and the third gap may together extend along an entire boundary of a region defined by being covered by the fist layer or the second layer.

The first (second, third) gap may refer to a region wherein the contact layer is spaced apart from the first layer and/or the second layer (the first layer and/or the substrate, the second layer and/or the substrate) by a distance exceeding a distance between the contact layer and the first layer in the overlap region. Alternatively, or in addition, the first (second, third) gap may refer to a region wherein the contact layer is spaced apart from the first layer and/or the second layer (the first layer and/or the substrate, the second layer and/or the substrate) by a distance exceeding a distance between the contact layer and the first (first, second) layer outside the overlap region, and preferably outside the boundary of the overlap region.

Respective distances may refer to distances along the vertical direction.

The superconductor material may comprise or be composed of aluminum.

The superconductor material may comprise or be composed of a transition metal with partly filled d-levels, such as Nb, NbN, or TiN. Alternatively, or in addition, the superconductor material may comprise or be composed of a superconductor material with a critical temperature of at least 4 K or at least 9 K.

The first electrically conductive line may comprise or be composed of the superconductor material and/or the second electrically conductive line may comprise or be composed of an additional superconductor material with properties corresponding to the ones described above in the context of the superconductor material. The additional superconductor material may have a material composition identical to or different from the one of the superconductor material.

The first and/or second layered material may comprise an element of the sixth main group of the periodic table of the elements, in particular oxygen. Alternatively or in addition, the first and/or second layered material may comprise an oxide and/or a chalcogenide.

Problems in the state of the art in contacting layered materials may be related to the content of the element of the sixth main group at the surface. For example, surfaces comprising an element of the sixth main group, such as oxygen, may be prone to chemical reactions, in particular at room temperature and higher temperatures, for example with solvents such as water and/or organic solvents. The chemical reactions may alter the content of the element of the sixth main group at the surface, resulting in a degradation of the superconducting material properties at the surface. The electrical contacting according to the present disclosure may solve this problem and therefore improve electronics devices with layered materials.

The first and/or second layered material may comprise a transition metal chalcogenide and/or a transition metal oxide, in particular a copper oxide.

The first layered material may comprise a second superconductor material and/or the second layered material may comprise a third superconductor material.

The first layered material may be composed of the second superconductor material.

The second layered material may be composed of the third superconductor material.

The first layered material may comprise a majority material composition identical to or different from a majority material composition of the second layered material.

The majority material composition may correspond to a material that constitutes at least 50%weight%, in particular at least 60 weight%, in particular at least 70 weight%, in particular at least 80 weight%, in particular at least 90 weight%, in particular at least 95 weight% or at least 98 weight% of the first (second) layered material.

The second and/or the third superconductor material may comprise or be a d-wave superconductor. The second and/or the third superconductor material may comprise a d-wave superconducting gap and/or be adapted for d-wave pairing. The d-wave superconductor may provide an order parameter with a d-wave symmetry.

The second and/or the third superconductor material may comprise or be a type-II superconductor.

The second and/or the third superconductor material may have a critical temperature of at least 4 K, in particular at least 8 K, in particular at least 15 K, in particular at least 30 K, in particular at least 50 K, in particular at least 70 K, in particular at least 78 K.

As laid out above, the improved electrical contacting is particularly useful for an electronics device based on superconductors, such as a Josephson junction device.

In particular, the practically viable implementation of a HTS qubit, and in general of a Josephson junction between HTS materials providing a quantum mechanical two-level system suitable for a qubit, remained a challenge in the state-of-the-art. The electrical contacting according to the present disclosure helps to solve this problem, provides a damage-free electrical contacting of the HTS.

The overlap region may be adapted to provide a Josephson junction between the first layered material and the second layered material. In particular, the section of the bottom surface of the second layer and the section of the top surface of the first layer may be adapted to provide the Josephson junction.

In the overlap region, the first layer and the second layer may be in direct physical contact with each other or be spaced apart from each other by no more than 5 nm.

The second superconductor material and/or the third superconductor material may comprise a critical temperature of at least 20 K or at least 30 K and/or may comprise or be composed of Bi₂Sr₂Caₙ₋₁CuₙO₂ₙ₊₄ with n =0, 1, 2, 3 (BSCCO).

According to embodiments, a thickness of the first (second) layer of the first (second) layered material in the overlap region may be at most 300 nm, in particular at most 200 nm, in particular at most 100 nm, in particular at most 50 nm, in particular at most 30 nm, in particular at most 20 nm, in particular at most 10 nm, in particular at most 5 nm.

The electronics device may comprise a distance corresponding to a predefined distance between the first layer and the second layer in the overlap region, in particular between the bottom surface of the second layer and the top surface of the first layer.

According to embodiments of the invention, the predefined distance maybe at least 0.2 nm, in particular at least 0.25 nm, in particular at least 0.3 nm, in particular at least 0.35 nm, in particular at least 0.4 nm, in particular at least 0.45 nm, in particular at least 0.5 nm.

According to embodiments of the invention, the predefined distance may be at most 10 nm, in particular at most 8 nm, in particular at most 6 nm, in particular at most 4 nm, in particular at most 3 nm, in particular at most 2 nm, in particular at most 1 nm.

The electronics device may comprise a spacer between the first layer and the second layer in the overlap region, in particular between the bottom surface of the second layer and the top surface of the first layer.

The spacer may be adapted to provide the distance corresponding to the predefined distance between the first layer and the second layer in the overlap region.

The spacer may have a single particle bandgap and/or a thickness adapted to adjust a tunnel barrier of a Josephson junction. According to embodiments, the thickness of the spacer in the overlap region varies by at most 0.3 nm, in particular by at most 0.2 nm, in particular by at most 0.1 nm, in particular by at most 0.05 nm.

The spacer may comprise a third layered crystal structure.

The electrical insulation element may comprise silicon nitride and/or at least one metal oxide.

The electrical insulation element may be composed of silicon nitride and/or at least one metal oxide.

The electric insulation element may comprise or be composed of at least one inorganic material.

The electric insulation element may comprise or be composed of at least one oxide, in particular at least one metal oxide, such as aluminum oxide.

According to embodiments, the first (second) layered material is anisotropic, for example in terms of its mechanical, optical, or electronic properties.

In the context of this disclosure, the (first and/or second) layered material may refer to a material with an anisotropy and/or layered structure at the atomic scale, i. e., in terms of its atomic structure, and/or in terms of its crystallographic structure (which may be uniaxial or biaxial).

In other words, the (first and/or second) layered material may be a (first and/or second) crystallographically layered material and/or a (first and/or second) atomically layered material.

The (first and/or second) layered material may exhibit an anisotropy due to its layered structure at the atomic scale or its layered crystallographic structure. The (first and/or second) layered material may exhibit the anisotropy on a super-atomic or macroscopic scale (0.1 µm, 1 µm, 10 µm, 100 µm, or 1 mm), for example in terms of its mechanical, optical, or electronic properties. The first and/or second layered material may be adapted to cleave along covalently bound atomic layers upon applying a tensile force.

In the context of this disclosure, the first layered material and/or the second layered material may refer to respective materials/a material comprising covalently bound atomic layers. A covalently bound atomic layer of the covalently bound atomic layers may comprise a nearest-neighbor atomic distance between nearest-neighbor atoms of the covalently bound atomic layer; and an interlayer distance between the covalently bound atomic layer and a covalently bound atomic layer neighboring the covalently bound atomic layer. The interlayer distance may exceed the nearest-neighbor atomic distance. The interlayer distance may exceed the nearest-neighbor atomic distance by at least 10%, in particular by at least 20%, in particular by at least 30% or by at least 40%.

Corresponding covalently bound atomic layers may constitute a majority of the first layered material and/or of the second layered material. The majority may refer to a mass fraction of at least 50%, in particular to at least 70%, in particular to at least 80%, in particular to at least 90%, in particular to at least 95% or to at least 98%.

In other words, in the context of this disclosure, the first layered material and/or the second layered material may refer to respective materials, wherein nearest-neighbor atoms of a same covalently bound atomic layer of the covalently bound atomic layers are bound to each other by covalent bonds. The covalently bound atomic layers may be bound to each other by van der Waals forces, in particular without covalent bonds between different (in particular, neighboring) covalently bound atomic layers.

A first section of a covalently bound atomic layer of the first layered material may be parallel to a second section of a covalently bound atomic layer of the second layered material. Alternatively, or in addition, a crystallographic layer of the first layered material may be parallel to a crystallographic layer of the second layered material.

In particular, the first (and/or the second) section of the covalently bound atomic layer of the first (and/or second) layered material may be comprised in or correspond to the overlap region. In particular, the respective first section may be arranged at the top surface of the first layer. Alternative, or in addition, the respective second section may be arranged at the bottom surface of the second layer. The crystallographic layer(s) may be characterized by corresponding features.

The crystallographic layer of the first (second) layered material may be perpendicular to a unique crystallographic axis of the first (second) layered material.

For example, the unique crystallographic axis may be a c-axis, a unique crystallographic axis of an uniaxial crystal, and/or an axis reflecting a direction of a longest primitive lattice vector.

The unique crystallographic axis of the first (second) layered material, maybe associated with a distinct direction of the first (second) layered material.

A corresponding arrangement of the layered materials is particularly beneficial for establishing vdW heterostructures, such as the HTS vdW heterostructure described above.

The first electrically conductive line and/or the second electrically conductive line may extend through the electrical insulation element between a bottom surface of the electrical insulation element and a top surface of the electrical insulation element.

At least one vertical reference line may intersect both the top surface and the bottom surface of the electrical insulation element. In particular, the at least one vertical reference line may intersect the top surface and/or the bottom surface of the electrical insulation element at a 90° angle.

The first electrically conductive line and/or the second electrically conductive line may extend along the at least one vertical reference line.

The first (second) electrically conductive line may comprise a contact adhesion material such as titanium or tantalum or a corresponding nitride.

The first (second) electrically conductive line may be adapted to provide superconductive current transport when the temperature of overlap region is below a critical temperature of the superconductor material and/or of the second superconductor material and/or of the third superconductor material.

A lateral extension of the substrate and/or of the contact layer may fully cover a lateral extension of the overlap region and/or of the first layer and/or of the second layer, for example to provide an encapsulation for the overlap region and/or the first layer and/or the second layer.

A lateral extension of the contact layer may fully cover a lateral extension of the overlap region.

Alternatively, or in addition, the electronics device may comprise an encapsulation of the overlap region and/or of the first layer and/or of the second layer, and the encapsulation may comprise at least a section of the substrate and/or at least a section of the contact layer, in particular of the electrical insulation element.

The electronics device may comprise an encapsulation of the overlap region, and the encapsulation may comprise at least a section of the contact layer.

The encapsulation may fully surround the overlap region and/or of the first layer and/or of the second layer.

The encapsulation may refer to a water-tight, a moisture-tight, an oxygen-tight and/or an airtight encapsulation.

The electrical insulation element maybe an electrical insulation layer, for example an electrical insulation layer hosting and/or encircling (in particular, in a horizontal plane) the electrically conductive lines.

The encapsulation of the overlap region may comprise and/or be provided by the electrical insulation layer. For example, the electrical insulation layer may be in direct physical contact with the first layer and/or the second layer and/or the substrate to provide the encapsulation.

In the overlap region, crystallographic orientations of the first layered material and the second layered material may differ.

A first crystallographic orientation may be parallel to a first crystallographic layer of the first layered material in the overlap region. A second crystallographic orientation may be parallel to a second crystallographic layer of the second layered material in the overlap region. The differing crystallographic orientations may refer to the first crystallographic orientation and the second crystallographic orientation.

The first (second) crystallographic orientation may be defined by a lattice vector, in particular a primitive lattice vector, parallel to the first (second) crystallographic layer of the first (second) layered material in the overlap region and/or parallel to a covalently bound atomic layer of the first (second) layered material in the overlap region.

Alternatively, or in addition, the differing crystallographic orientations may refer to the order parameter and/or the d-wave symmetry of the order parameter of the second and/or the third superconductor material.

Alternatively, or in addition, the differing crystallographic orientations may refer to different orientations of corresponding lattice vectors of the (first and second) layered materials parallel to respective covalently bound atomic layers of the (first and second) layered materials, in particular at the bottom surface of the second layer and at the top surface of the first layer and/or in the overlap region. The respective covalently bound atomic layer(s) of the first layered material may be parallel to the top surface of the first layer in the overlap region. The respective covalently bound layer(s) of the second layered material may be parallel to the bottom surface of the second layer in the overlap region.

A layer of an elastomer may be arranged over the contact layer.

The layer of the elastomer may be arranged over the contact layer in direct physical contact with the contact layer.

The elastomer may comprise a glass transition temperature of at most 0°C, in particular at most -20°C, in particular at most -40°C, in particular at most -60°C, in particular at most-80°C, in particular at most -100°C, in particular at most -120°C or at most -140°C.

The elastomer may comprise or be an elastic polymer such as polydimethylsiloxane.

The electronics device may comprise a contact region in which the first layer is arranged over the substrate, wherein the second layer does not extend into the contact region; and wherein the first electrical contact is arranged in the contact region.

A thickness of the contact layer and/or of the electrical insulation element may not exceed 100 µm or not exceed 50 µm, or not exceed 25 µm, or not exceed, 10 µm or not exceed 1 µm, or not exceed 500 nm.

Alternatively, or in addition, the contact layer and/or of the electrical insulation element may be mechanically flexible.

The substrate may comprise a surface in the overlap region; the first layer and/or the second layer may be arranged over the surface, and at least a section of a covalently bound layer of the first layered material and/or of the second layered material may be parallel to the surface of the substrate.

In particular, the section of the bottom surface of the second layer and the section of the top surface of the first layer parallel to each other may be parallel to the surface of the substrate and/or comprise the respective covalently bound layers parallel to the surface of the substrate.

The first electrical contact and/or the second electrical contact may refer to an Ohmic contact or to a capacitive contact.

In other words, an electrically conductive material comprised in the first (and/or second) electrically conductive line may be in direct physical contact with the first (and/or second) layer at the first (and/or second) electrical contact; or a spacer may be arranged between the electrically conductive material comprised in the first (and/or second) electrically conductive line and the first (and/or second) layer. The spacer may comprise or be composed of a solid, a liquid, a gas, and/or vacuum.

The spacer may be adapted to chemically passivate the bottom surface of the second layer and/or the top surface of the first layer. For example, the spacer may be impermeable to a reactive species, such as oxygen and/or chalcogenides and/or water and/or organic solvent. For example, the spacer may be arranged to fully cover the section of the top surface.

The first (second) electrical contact may comprise a van der Waals bond between the first (second) electrically conductive line and the first (second) layer, in particular without covalent bonds between the first (second) electrically conductive line and the first (second) layer.

According to a second aspect, a method for fabricating an electronics device comprises providing a substrate; providing a first layer of a first layered material over the substrate; and providing a contact layer separate from the first layer. The contact layer comprises a plurality of electrically conductive lines comprising a first electrically conductive line; and an electrical insulation element. The electrical insulation element is arranged between the electrically conductive lines to electrically insulate them from each other. The method further comprises cooling the first layer to a temperature below a first temperature of o°C; and arranging the contact layer over the first layer, such that a first electrical contact is formed between the first electrically conductive line and the first layer.

The first layered material and/or the second material may be chemically stable when their/its temperature are/is below the first temperature. In other words, the first temperature may be selected such that the first layered material and/or the second material is chemically stable when their/its temperature are/is below the first temperature.

The method may comprise selecting the first temperature (of at most o°C) such that the first layered material and/or the second material is chemically stable when their/its temperature are/is below the first temperature,

The method may further comprise, prior to the arranging the contact layer over the first layer, providing a second layer of a second layered material over the substrate; wherein, in an overlap region, the second layer is arranged over the first layer, and a section of a bottom surface of the second layer is arranged parallel to a section of a top surface of the first layer. The contact layer may be provided separate from the first layer and the second layer. The plurality of electrically conductive lines may comprise a second electrically conductive line. The method may comprise, prior to the arranging the contact layer over the first layer, cooling the second layer to a temperature below the first temperature. The method may comprise, in addition to arranging the contact layer over the first layer, arranging the contact layer over the second layer, such that a second electrical contact is formed between the second electrically conductive line and the second layer.

According to embodiments, the method further comprises, during the process step of cooling the first layer to a temperature below the first temperature and/or during the process step arranging the contact layer over the first layer, controlling a partial pressure of water of an atmosphere adjacent to the first layered material and/or the second layered material in the overlap region, in particular controlling the partial pressure of water to be below 0.01 Pa, in particular below 0.001 Pa, in particular below 0.0001 Pa.

During at least one of those process steps, the atmosphere adjacent to the first layered material and/or the second layered material in the overlap region may comprise a total pressure of at least 10⁴ Pa, in particular at least 5 x 10⁴ Pa, in particular at least 9 x 10⁴ Pa, in particular at least 10⁵ Pa. For example, the total pressure of the atmosphere adjacent to the first surface and/or the second surface may correspond to an environmental pressure, and/or exceed the environmental pressure by at most 5%, in particular by at most 3%, in particular by at most 1%.

During at least one of those process steps, the atmosphere adjacent to the first layered material and/or the second layered material in the overlap region may comprise a partial pressure of organic solvents below 0.01 Pa, in particular below 0.001 Pa, in particular below 0.0001 Pa.

The first temperature may be 250 K, or 230 K, or 210 K, or 190 K, or 170 K, or 150 K, or 130 K.

The arranging the contact layer over the first layer (and the second layer) may refer to transferring the contact layer onto the first layer (and the second layer).

The substrate, the first layer, the second layer, and/or the contact layer may be characterized by one or all the features described above in the context of the electronics device. For example, the first electrically conductive line and/or or the second electrically conductive line may comprise or be composed of a superconductor material or respective superconductor materials.

The method may further comprise keeping the first layer (and/or the second layer) at a temperature below the first temperature while arranging the contact layer over the first layer (and the second layer).

The method may further comprise keeping the transfer device at a temperature below the first temperature while arranging the contact layer over the first layer (and the second layer).

The method may further comprise keeping the first layer (and/or the second layer) at a temperature below the first temperature while arranging the contact layer over the first layer (and the second layer).

The providing the contact layer separate from the first layer (and the second layer) may comprise fabricating the contact layer over a second substrate different from the substrate.

The fabricating the contact layer over a second substrate different from the substrate may comprise depositing an etch stop layer over the second substrate.

The fabricating the contact layer over a second substrate different from the substrate may comprise depositing a sacrificial layer over the second substrate.

The fabricating of the contact layer over a second substrate different from the substrate may comprise depositing a layer of insulation material over the second substrate.

The fabricating the contact layer over a second substrate different from the substrate may comprise forming the electrically conductive lines in the layer of insulation material.

The forming of the electrically conductive lines in the layer of insulation material may comprise structuring the layer of insulation material, for example by etching the layer of insulation material.

The forming of the electrically conductive lines in the layer of insulation material may comprise depositing a conductive material (in particular, a superconductor material) over and/or into the layer of insulation material.

The method may comprise attaching the transfer device to the contact layer arranged over the second substrate, in particular while keeping the transfer device and/or the second substrate at a temperature below the first temperature.

The transfer device may be adapted to provide a strong adhesion when the temperature of the transfer device is below a third temperature.

The third temperature may be no larger than the first temperature.

The method may comprise removing the transfer device arranged over the second substrate and/or over the contact layer from the second substrate, while keeping the transfer device and/or the second substrate and/or the contact layer at a temperature below the third temperature.

The method may comprise separating the contact layer from the second substrate. Alternatively, or in addition, the method may comprise generating a flexible contact layer and/or the contact layer arranged on the transfer device.

The method may comprise etching the sacrificial layer and/or the second substrate to separate the contact layer from the second substrate; in particular to generate the flexible contact layer and/or the contact layer arranged on the transfer device.

The transfer device may be adapted to provide a weak adhesion (in particular, weaker than the strong adhesion) when the temperature of the transfer device is above a second temperature.

Arranging the contact layer over the first layer and the second layer may comprise providing a transfer device with the contact layer arranged thereon (in particular at a temperature below the third temperature); and heating the transfer device to release the contact layer therefrom and over the first layer (and the second layer); in particular heating the transfer device to a temperature between the second temperature and the first temperature.

The first temperature may be higher than the second temperature. The second temperature may be higher than the third temperature.

The transfer device may comprise or be composed of an elastomer, in particular an elastomer with one or all the features described above in the context of the electronics device.

The second temperature may be -10°C, in particular -15°C, in particular -20°C, in particular - 25°C, -30°C, or -35°C, or -40°C, or -45°C or -50°C, or -55°C, or -60°C.

The second temperature may correspond to the first temperature, or to the first temperature plus 10 K, or to the first temperature plus 20 K, or to the first temperature plus 30 K, or to the first temperature plus 40 K, or to the first temperature plus 50 K, or to the first temperature plus 60 K, or to the first temperature plus 70 K.

The third temperature may be -150°C, or -140°C, or -130°C, or -120°C, or -110°C or -100°C or -90°, or -80°C, or -70°C, -60°C, or -50°C, or -40°C, or -30°C.

According to embodiments, providing the first layer of the first layered material over the substrate comprises cleaving the first layered material, and/or cleaving the second layered material. In particular, cleaving the first and/or second layered material may comprise using an elastomer.

Cleaving may produce a first (second) surface corresponding to a bulk material prior to the cleaving. In other words, contaminations or defects of the prior surface may be removed.

### BRIEF DESCRIPTION OF THE FIGURES

The techniques of the present disclosure and the advantages associated therewith will be best apparent from a description of exemplary embodiments in accordance with the accompanying drawings, in which:
- Fig. 1A: shows a perspective view of an electronics device according to a first embodiment;
- Fig. 1B: shows a cross sectional view of an electronics device according to the first embodiment;
- Fig. 2: shows an electronics device according to another embodiment;
- Fig. 3: shows an electronics device according to another embodiment;
- Fig. 4: shows a method for fabricating an electronics device according to an embodiment;
- Fig. 5: shows a method for providing a contact layer;
- Fig. 6a: shows an intermediate step of a method for providing a contact layer;
- Fig. 6b: shows an intermediate step of a method for providing a contact layer;
- Fig. 6c: shows an intermediate step of a method for providing a contact layer;
- Fig. 6d: shows an intermediate step of a method for providing a contact layer;
- Fig. 7a: shows another intermediate step of a method for providing a contact layer;
- Fig. 7b: shows another intermediate step of a method for providing a contact layer;
- Fig. 7c: shows another intermediate step of a method for providing a contact layer;
- Fig. 7d: shows another intermediate step of a method for providing a contact layer;
- Fig. 8a: shows another intermediate step of a method for providing a contact layer;
- Fig. 8b: shows another intermediate step of a method for providing a contact layer;
- Fig. 8c: shows another intermediate step of a method for providing a contact layer;
- Fig. 8d: shows another intermediate step of a method for providing a contact layer;
- Fig. 9a: shows another intermediate step of a method for providing a contact layer;
- Fig. 9b: shows another intermediate step of a method for providing a contact layer;
- Fig. 9c: shows another intermediate step of a method for providing a contact layer;
- Fig. 9d: shows another intermediate step of a method for providing a contact layer;
- Fig. 10a: shows another intermediate step of a method for providing a contact layer;
- Fig. 10b: shows another intermediate step of a method for providing a contact layer;
- Fig. 10c: shows another intermediate step of a method for providing a contact layer;
- Fig. 10d: shows another intermediate step of a method for providing a contact layer;
- Fig. 11a: shows another intermediate step of a method for providing a contact layer;
- Fig. 11b: shows another intermediate step of a method for providing a contact layer;
- Fig. 11c: shows another intermediate step of a method for providing a contact layer;
- Fig. 11d: shows another intermediate step of a method for providing a contact layer;
- Fig. 12a: shows a product of the method for fabricating an electronics device;
- Fig. 12b: shows another product of the method for fabricating an electronics device;
- Fig. 12c: shows another product of the method for fabricating an electronics device;
- Fig. 12d: shows another product of the method for fabricating an electronics device;
- Fig. 12e: shows another product of the method for fabricating an electronics device;
- Fig. 13: shows method for providing a layer of a layered material over a substrate;
- Fig. 14: shows an apparatus for providing a layer of a layered material over a substrate;
- Fig. 15: shows a method for fabricating an electronics device according to an embodiment; and
- Fig. 16: shows a method for fabricating external wiring to an electronics device.

### DETAILED DESCRIPTION OF EMBODIMENTS

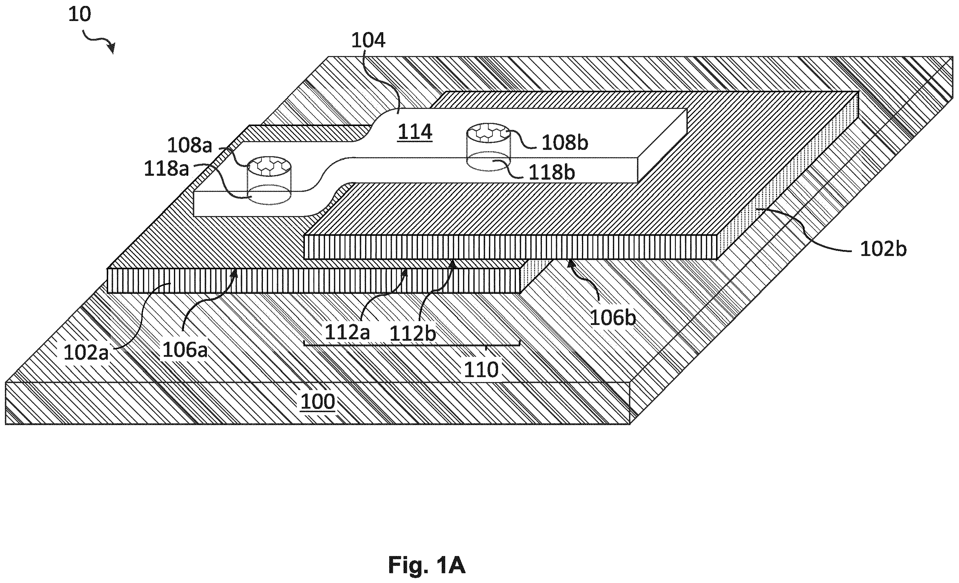

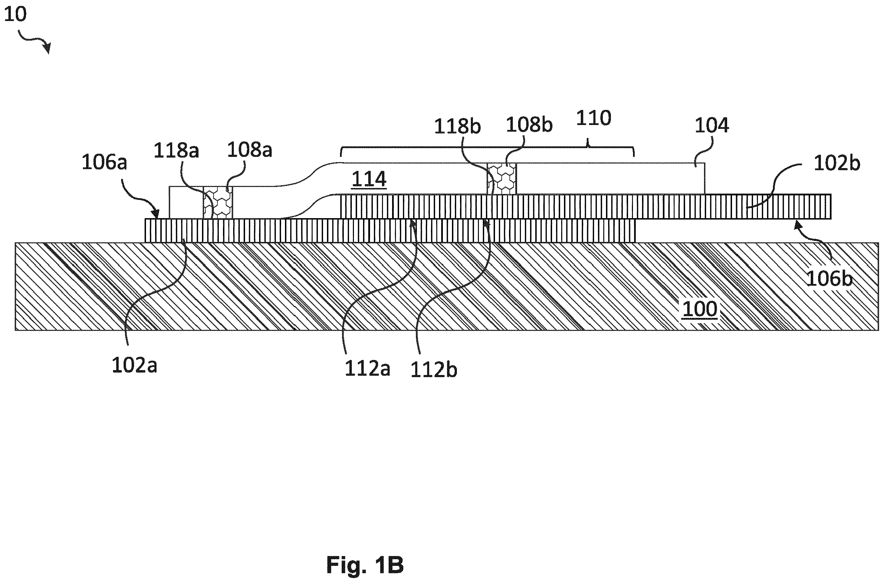

Fig. 1A gives a perspective view of an electronics device with two layers 102a, 102b of layered materials, and Fig. 1B gives a cross section of the electronics device.

The layers 102a, 102b overlap in an overlap region 110. In other words, in the overlap region 110 the layers 102a, 102b form a stack. A stack of at least two layers 102a, 102b of layered materials is also referred to as a vdW heterostructure in the context of this disclosure.

More specifically, in the overlap region 110 a section 112a of a top surface 106a of the first layer 102a faces a section 112b of a bottom surface 106b of the second layer 102b, and the two surfaces 106a, 106b are arranged parallel to each other.

According to the depicted embodiment, the layered materials are both layered, high-temperature (cuprate) superconductors, more specifically Bi2Sr2Can-1CunO2n+4 (BSCCO) with n = 2. Consequently, the exemplary electronics device of Fig. 1A, Fig. 1B is a Josephson junction device. The Josephson junction device is preferably formed as a twist Josephson junction device, i. e. crystallographic orientations 620, 622 of the layers 102a, 102b are rotated (twisted) with respect to each other around a vertical axis. However, according to alternative embodiments, other layered materials such as transition metal dichalcogenides are employed to establish a different electronics device, for example an optoelectronics device.

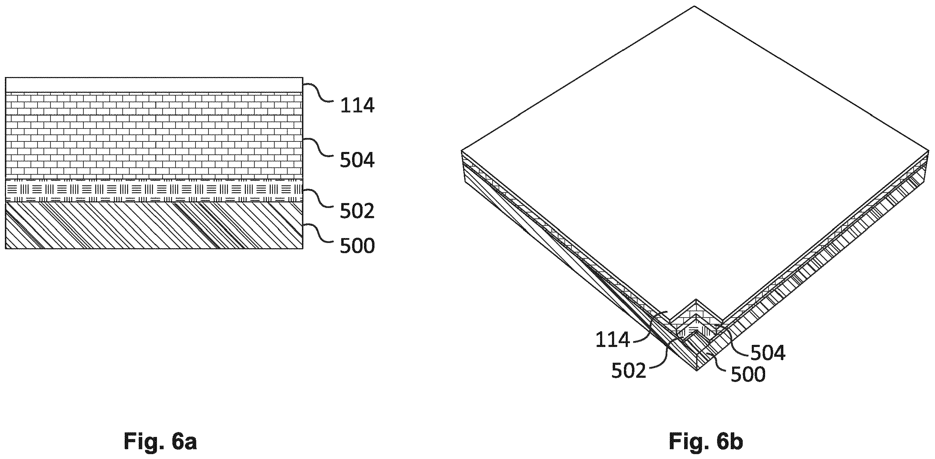

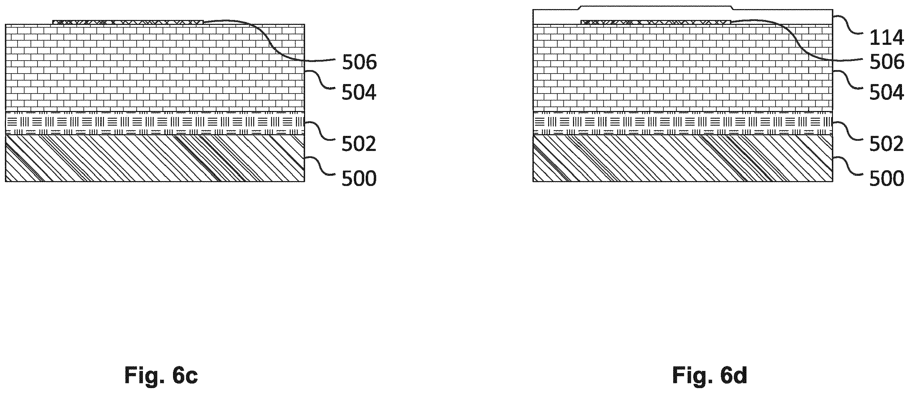

An exemplary technique to form the vdW heterostructure is described below in the context of Fig. 6. Alternative formation techniques for the vdW heterostructure comprise stamping, evaporation, chemical vapor deposition, or the scotch tape method. The different techniques may be combined in the formation of the vdW heterostructure.

The vdW heterostructure 102a, 102b is supported by a substrate 100. The disclosed method permits to form the vdW heterostructure 102a, 102b substrates 100 with various material compositions and geometries (thicknesses). In other words, a substrate 100 with a material composition or geometry tailored to a specific application is used. For the depicted Josephson junction device, a dielectric or semiconducting substrate 100 is used, such as silicon covered with an oxide or a flexible organic film. In case of an optoelectronics device, a transparent substrate 100, such as a transparent oxide or a transparent and flexible organic film, is used.

The electronics device of Fig. 1A, Fig. 1B further comprises a contact layer 104. The contact layer 104 comprises an electrical insulation element 114 and electrically conductive lines 108a, 108b separated and electrically insulated by the electrical insulation element 114. Electrical contacts 108a, 108b are formed between the electrically conductive lines 108a, 108b and the layers 102a, 102b.

The contact layer 104 of Fig. 1A, Fig. 1B comprises an insulating film 114 as the electrical insulation element 114. The insulating film 114 was prepared on a separate substrate, structured, and metallized to form the electrically conductive lines 108a, 108b thereunder, therein and/or thereon and to establish the contact layer 104. The contact layer was then mechanically transferred onto the vdW heterostructure 102a, 102b.

Consequently, a wide range of materials may be applied in the insulating film 114 and the electrically conductive lines 108a, 108b.

According to the depicted embodiment, the electrically conductive lines 108a, 108b are made from a superconductor material such as Al, Nb, NbN, or TiN. For operation, the Josephson junction device is cooled down below the critical temperature of the superconductor material, bringing both the superconductor material of the conductive lines 108a, 108b and the vdW heterostructure 102a, 102b into the superconducting state. In this state, the electrically conductive lines 108a, 108b pose superconducting leads to the vdW heterostructure 102a, 102b, reducing energy dissipation in the device and improving its efficiency.

In alternative embodiments, the electrically conductive lines 108a, 108b comprise metal stacks to provide a predefined work function and/or contact potential (e. g., in a logical device such as a transistor or in a diode such as a photo- or light-emitting diode) or a contact layer (comprising, e. g., Ti or Ta or a nitride thereof) to improve adhesion to the vdW heterostructure 102a, 102b.

According to alternative embodiments, the electrically conductive lines 108a, 108b comprise or consist of a noble metal such as gold to optimize their resistivity (with respect to a non-superconducting state) and/or their chemical inertness. In corresponding embodiments, the noble metal may be part of a metal stack as described above.

According to the depicted embodiment, the insulating film 114 has a multilayer structure of AlOx and SiN. This material composition provides excellent encapsulation and passivation properties, to optimize protection of the VdW heterostructure 102a, 102b from chemical decomposition due to (e. g. atmospheric) water, moisture, and oxygen. Moreover, the insulating film 114 made from AlOx and SiN is optically transparent, which is beneficial for optoelectronics applications.

In alternative embodiments, the insulating film 114 comprises or is composed of a nitride or a fluoride or an organic material such as PTFE or PDMS.

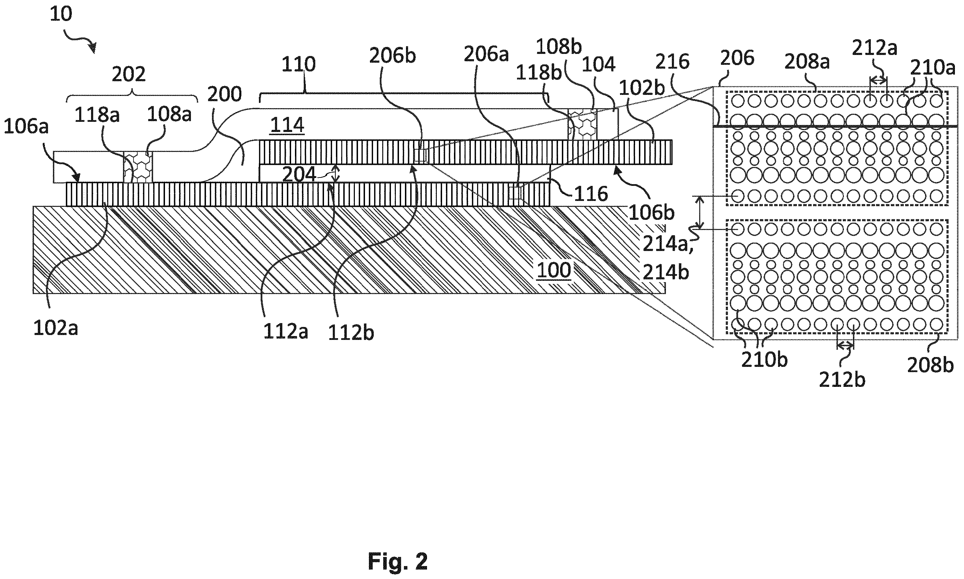

Fig. 2 shows an electronics device according to an embodiment similar to the one of Fig. 1A, Fig. 1B. Similar elements have same reference numerals and will not be described again. The electronics device according to the embodiment of Fig. 2 is formed with several modifications. According to different embodiments, electronics devices are formed with any or any combination of these modifications.

The electronics device of Fig. 2 comprises a contact region 202 with the first electrical contact 118a. The first layer 102a extends laterally into the contact region 202 whereas the second layer 102b does not, leaving the first layer 102a exposed from the second layer 102b. The first contact 118a is made in this region 202.

The electronics device of Fig. 2 comprises a first gap 200 between the contact layer 104 and the first layer 102a as well as the second layer 102b. The gap 200 is a consequence of the transfer of the contact layer 104 onto the stack 102a, 102b. The gap 200 extends along a section of the boundary of the overlap region 110, more specifically along the boundary between the overlap region 110 and the contact region 202.

The electronics device of Fig. 2 comprises a spacer 116. The spacer 116 is formed from a dielectric material. According to the depicted embodiment, the spacer 116 is formed from hexagonal boron nitride, a dielectric (crystallographically and/or atomically) layered material, with its crystallographic layers oriented parallel to the surfaces 106a, 106b. The spacer 116 provides a defined distance 204 between the surfaces 106a, 106b, which is preselected to adjust the (tunneling) current therebetween.

Fig. 2 also presents a close-up 206 of exemplary regions 206a, 206b of the layered materials 102a, 102b in the overlap region 110. The close-up 206 shows the exemplary regions 206a, 206b to such detail that the atoms 210a, 210b therein are resolved. The atoms 210a, 210b of the layered materials form covalently bound atomic layers 208a, 208b of the atoms 210a, 210b. A covalently bound atomic layer 208a, 208b is characterized by nearest neighbor atomic distances 210a, 210b therein being smaller than an interlayer distance 214a, 214b between the covalently bound atomic layer 208a, 208b and a neighboring covalently bound atomic layer 208b, 208a. The interlayer distance 214a, 214b refers to the distance between an atom of the covalently bound atomic layer 208a, 208b closest to the neighboring covalently bound atomic layer 208b, 208a and an atom of the neighboring covalently bound atomic layer 208b, 208a closest to the covalently bound atomic layer 208a, 208b.

The small nearest neighbor atomic distance 210a, 210b within the covalently bound atomic layer 208a, 208b is related to predominantly covalent bonds between the atoms 210a, 210b within the covalently bound atomic layer 208a, 208b.

The large interlayer distance 214a, 214b between the covalently bound atomic layers 208a, 208b is related to predominantly van der Waals bonds between the covalently bound atomic layers 208a, 208b (or between the atoms of one covalently bound atomic layer 208a, 208b and the neighboring covalently bound atomic layer 208b, 208a, respectively).

Covalent bonds are typically (mechanically) much stronger than van der Waals bonds, i. e. they can withstand larger forces. Therefore, upon applying a tensile force to the layered materials 102a, 102b (e. g., perpendicular to the covalently bound atomic layers 208a, 208b), the layered materials 102a, 102b are typically cleaved (broken apart) along an interface between the covalently bound atomic layers 208a, 208b. At the interface, the covalently bound atomic layers 208a, 208b are bound to each other predominantly by van der Waals forces. Such an interface is also referred to as a van der Waals gap.

The layers 102a, 102b have been prepared by such cleaving. Consequently, the surfaces 106a, 106b are parallel to covalently bound atomic layers 208a, 208b and van der Waals gaps of the layered materials.

The van der Waals gap may thus be considered to define a plane of the layered material of the layers 102a, 102b; i. e. the plane along which the covalently bound atomic layers 208a, 208b extend. Alternatively, the plane may be defined by directions parallel to rows of atoms within the respective covalently bound atomic layer 208a, 208b.

Fig. 2 also depicts a crystallographic plane (crystallographic layer) 216 of the layered material of the close-up 206. The crystallographic plane 216 is parallel to the directions of rows of atoms in the covalently bound atomic layers 208a, 208b. The crystallographic plane and its orientation can be measured using, for example, diffraction techniques. Accordingly, the crystallographic plane and its orientation are not defined by a single covalently bound atomic layer 208a, 208b or the atoms 210a, 210b therein, but by an average plane along which the covalently bound atomic layers 208a, 208b (or the atoms 210a, 210b therein, respectively) extend.

Respective crystallographic planes 216 of the layers 102a, 102b are parallel to each other, at least in (part of) the overlap region 110.

According to the depicted embodiment, the first layer 102a and the second layer 102b are composed of the same layered material depicted in the close-up 206. According to alternative embodiments, the layers 102a, 102b are composed of different layered materials. In such embodiments, details regarding the type and the arrangement of the atoms 210a, 210b within the covalently bound atomic layers 208a, 208b differ for the different (layers 102a, 102b and/or regions 206a, 206b of the) layered materials. However, for each layered material separately, a close-up 206, covalently bound atomic layers 208a, 208b, nearest neighbor atomic distances 210a, 210b, interlayer distances 214a, 214b, van der Waals gaps, and a crystallographic layer 216 are defined as described above. According to such embodiments, the (plane or directions of the) covalently bound atomic layers 208a, 208b, the van der Waals gap, and/or the crystallographic plane 216 of the layered material of the first (second) layer 102a (102b) are parallel to the top surface 106a (bottom surface 106b).

In summary, the close-up 206 thus illustrates a layered structure at the atomic level, or of the crystal(lographic) structure, respectively, characteristic of a layered material 102a, 102b.

The layered materials of the disclosure may be characterized by a corresponding layered structure at the atomic level. Alternatively, or in addition, they may be characterized by anisotropies in the macroscopic world, for example with respect to their mechanical properties. In particular, cleaving (mechanically breaking apart) the layered materials between their covalently bound atomic layers 208a, 208b is achieved more easily (i. e., upon applying a much smaller force) than breaking the bonds within their respective layers.

A layered material of the disclosure may also be referred to as crystallographically layered material, an atomically layered materials, a van der Waals materials, or as a stack/crystal of an associated 2D material (wherein the associated 2D material may consist of a single layer of the layered material).

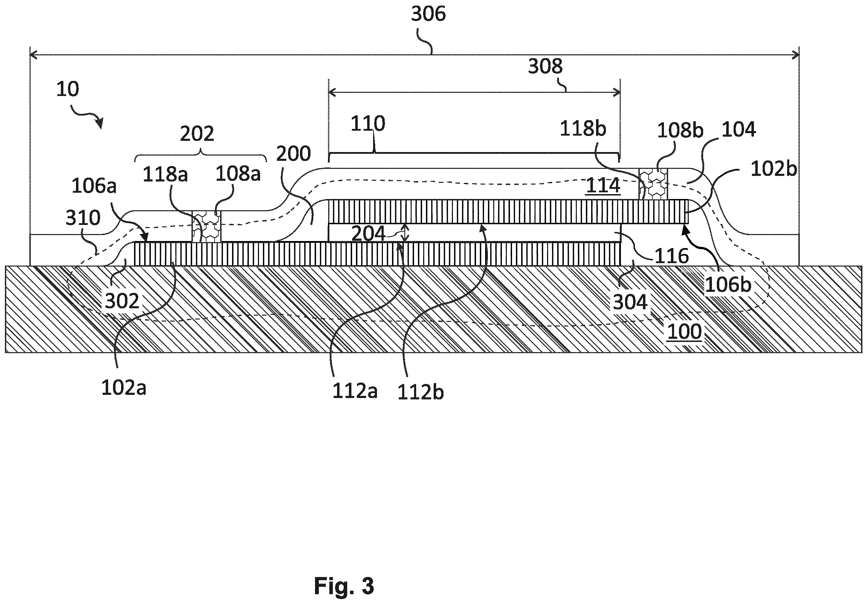

Fig. 3 shows an electronics device according to an embodiment similar to the one of Fig. 1A, Fig. 1B, and Fig. 2. Similar elements have same reference numerals and will not be described again. The electronics device according to the embodiment of Fig. 3 is formed with several modifications. According to different embodiments, electronics devices are formed with any or any combination of these modifications.

According to the depicted embodiment, the first layer 102a, the second layer 102b and the overlap region 110 are surrounded by an encapsulation 310 comprising the substrate 100 and the contact layer 104. The encapsulation 310 provides a watertight, moisture tight, oxygen tight and airtight protection of the layers 102a, 102b and the overlap region 110.

For this purpose, the contact layer 104 is formed with the lateral extension 306 that fully covers the lateral extension 308 of the overlap region 110.

According to the depicted embodiment, the lateral extension of the contact layer 104 also covers the lateral extension of the first layer 102a fully. Consequently, a second gap 302 is formed between the contact layer 104 and the first layer 102a as well as the substrate 100 at a boundary of the first layer 102a and/or the contact region 202, respectively.

According to the depicted embodiment, the lateral extension of the contact layer 104 also covers the lateral extension of the second layer 102b fully. Consequently, a third gap 304 is formed between the contact layer 104 and the second layer 102b as well as the substrate 100 at a boundary of the second layer 102b.

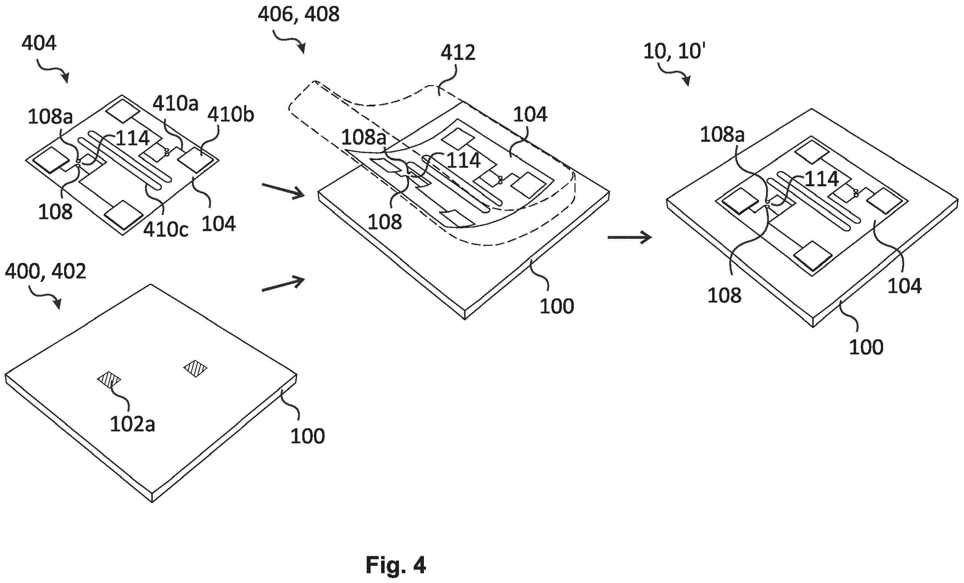

Fig. 4 depicts a method for fabricating the electronics device.

At steps 400, 402 the substrate 100 is provided and the first layer 102a is provided thereover.

For this purpose, at step 400, a substrate is provided as described above.

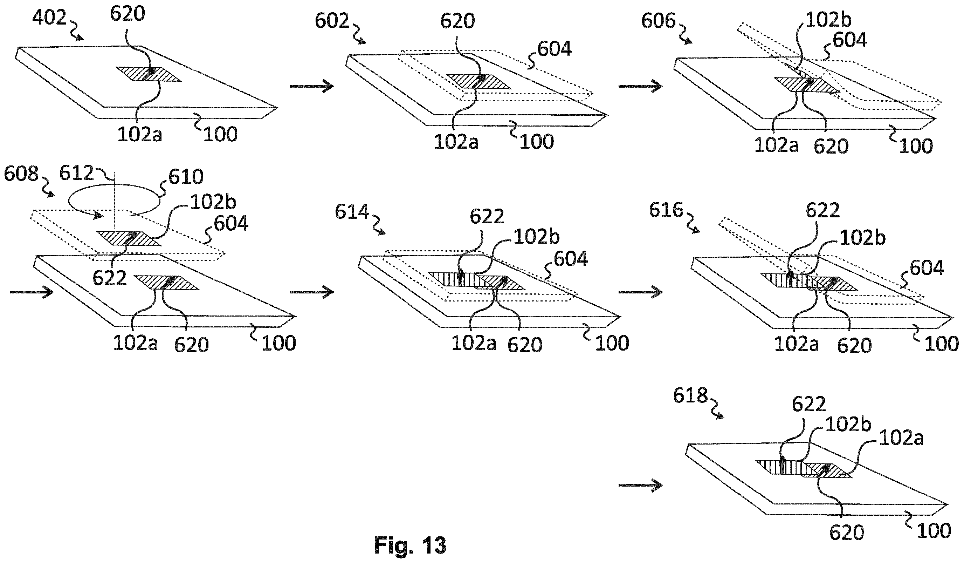

Thereafter, the first layer 102a is arranged on the substrate at step 402. For this purpose, a preprepared layer 102a of the first layered material is transferred onto the substrate 100, for example as described in detail in the context of Fig. 13 for the second layer 102b. Alternatively, the first layer 102a may be deposited onto the substrate (e. g. reactively) from a gas phase or using a vacuum deposition technique, such as chemical vapor deposition or molecular beam epitaxy.

According to the depicted embodiment, a single layer 102a of a first layered material is arranged over the substrate 100 in step 402. According to alternative embodiments, several layers 102a, 102b are arranged over the substrate 100, for example to form an overlap region 110. A method for providing the layers 102a, 102b will be described below in the context of Fig. 13.

At step 404, the contact layer 104 is provided separately from the first layer.

The contact layer 104 comprises the insulation element 114 in the form of a dielectric layer and the electrically conductive lines 108, 108a.

The contact layer 104 optionally comprises additional electrical components such as electrically conductive leads 410a, bond pads 410b, and an antenna 410c.

At steps 406, 408 the contact layer 104 is cooled 406 with liquid-nitrogen to a temperature < -85°C (third temperature) and arranged over the first layer 102a.

For this purpose, the contact layer 104 is arranged on a PDMS stamp 412 serving as a transfer device 412. Contact layer 104 and transfer device 412 are cooled 406 below the third temperature. Below the third temperature, the PDMS stamp 412 provides a strong adhesion to the contact layer 104.

Then, the PDMS stamp 412 and the contact layer 104 arranged thereon are positioned over and physical contact with the substrate 100 and the first layer 102a thereover. Thereby, the contact layer 104 is arranged 408 over the first layer 102a.

In an optional additional step, the PDMS stamp 412 is removed from the contact layer 104. For this purpose, the PDMS stamp 412 is heated to a temperature > -30°C (second temperature). This reduces the adhesion of the PDMS stamp 412. Consequently, the PDMS stamp may be removed, leaving the contact layer 104 arranged 408 over the first layer 102a.

To avoid thermal damage to the first layer 102a, the temperature of the first layer 102a is kept below o°C (first temperature) by keeping the temperature of the PDMS stamp 412 below the first temperature while the PDMS stamp 412 is in contact with the substrate 100 and/or the first layer 102a.

The reduced adhesion of the PDMS stamp 412 at elevated temperature (as compared to the third temperature of -85°C) is related to the amorphous molecular structure of the PDMS with a glass transition temperature of around -100°C. Consequently, the second temperature and the third temperature are both above the glass transition temperature of the PDMS (-150°C). For temperatures above the glass transition temperature, the adhesion of elastic polymers decreases with increasing temperature. In other words, an alternative material may be used for the transfer device 412 instead of PDMS, in particular an elastic polymer for as long as its glass transition temperature is below the second temperature (and the third temperature).

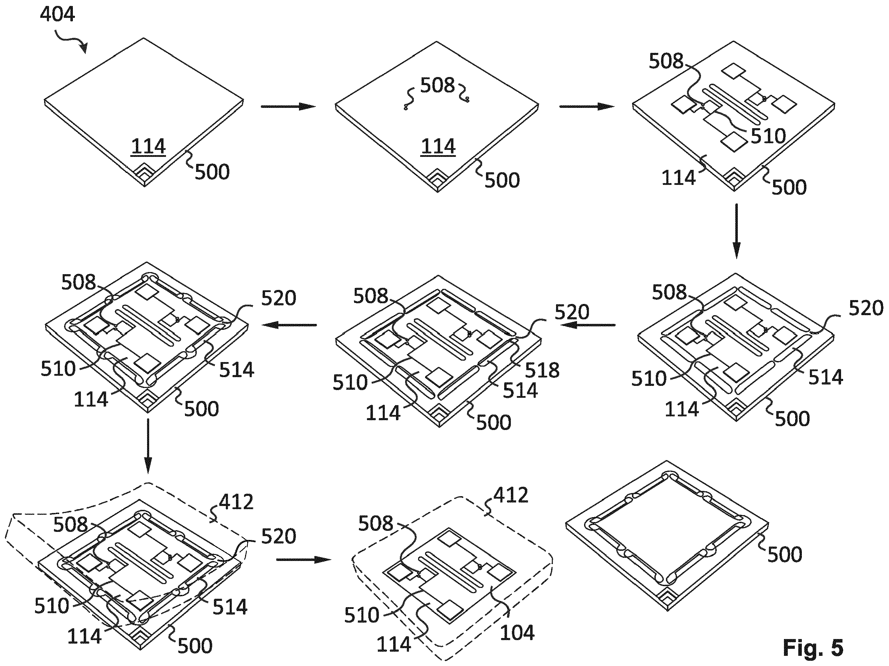

Fig. 5 gives details of the process step of providing 404 the contact layer 104 separately from the first layer 102a according to an embodiment.

First, a layer 114 of insulating material is deposited onto a second substrate 500 remote from the substrate 100.

Openings 508 are etched through the layer 114 of insulating material.

A metallization layer 510 is deposited over the openings 508. Consequently, a conductive line is formed reaching down to a bottom surface of the layer 114 of insulating material through the opening 508.

The metallization layer 510 is optionally also used to form the additional electrical components 410a, 410b, 410c.

A trench 514 is then formed in the layer 114 of insulating material. The trench 114 reaches down to the bottom surface of the layer 114 of insulating material, or cuts through the layer 114 of insulating material, respectively. The trench 514 is laterally interrupted by sections 520 of insulation material 114 serving as anchor points (teathers).

A deeper (than the trench 514) trench 518 is then formed, reaching into the second substrate 500 and/or into an optional sacrificial layer between the second substrate 500 and the layer 114 of insulating material. In other words, if a distinct sacrificial layer is absent, a (top) sacrificial portion of the second substrate 500 serves as the sacrificial layer.

An isotropic etch is then performed to remove the sacrificial layer and/or the sacrificial portion of the second substrate 500 below the layer 114 of insulating material in the lateral region within the deeper trench 518. Consequently, the resulting contact layer 104 is free-standing with respect to the second substrate 500.

Prior to or after the isotropic etch, the PDMS stamp 412 is attached to (transferred onto) the layer 114 of insulating material with the openings 508 (which may be entirely filled with the metallization layer 510 at this point). The PDMS stamp 412 is cooled to a temperature below the third temperature; the cooling may be performed before or after transferring the PDMS a stamp 412 onto the layer 114 of insulating material with the openings 508.

The cooled PDMS stamp 412 is removed from the second substrate 500 while being cooled. The PDMS cooled below the third temperature provides a strong adhesion. Consequently, removing the PDMS stamp 412 from the second substrate 500 lifts the contact layer 104 off from the second substrate 500 as the contact layer 104 adheres strongly to the PDMS stamp 412.

Consequently, the contact layer 104 remains arranged on the PDMS stamp 412 and is separated from the substrate 500.

Optionally, the contact layer 104 is cleaned at its bottom surface (facing away from the PDMS stamp 412), for example a wet and/or dry cleaning step such as etching, ion-milling. If applied, the cleaning step is preferably performed just before arranging the contact layer 104 over the substrate 100.

Fig. 6a to Fig. 11d give details of the process step of providing 404 the contact layer 104 separately from the first layer 102a according to an embodiment. The embodiment may be similar to the one described in the context of Fig. 5. Similar elements are indicated with same reference numerals.

Fig. 6a depicts a cross section of an intermediate product after a deposition step (for providing 404 the contact layer 104 separately from the first layer 102a) according to an embodiment. Fig. 6b gives a perspective view of the intermediate product.

In the deposition step, a layer 114 of insulating material is deposited over a second substrate 500. The depicted layer 114 of insulating material is a stack of AlOₓ/SiNₓ/AlOₓ deposited using atomic layer deposition (ALD) and chemical vapor deposition (CVD) techniques. However, a variety of insulating materials may be applied in the layer 114 depending on the requirements of a specific electronics device. Corresponding insulating materials may be deposited using CVD, ALD, physical vapor deposition, and/or a sputter deposition techniques.

Optionally, and etch stop layer 502 and/or a sacrificial layer 504 is/are deposited over the second substrate 500 prior to depositing the layer 114 of insulating material.

According to the depicted embodiment (first alternative), the second substrate 500 is a silicon-on-insulator (SOI) wafer. The SOI wafer comprises a bottom silicon substrate, a layer of silicon oxide over the silicon substrate, and a top layer of silicon thereover. In this context, the layer of silicon oxide is also referred to as a buried oxide layer. According to a second alternative, the substrate consists of a silicon wafer with a silicon oxide thereon. According to alternative embodiments, a silicon wafer with a top oxide, a bare silicon wafer or an oxide substrate (such as sapphire or glass) with a top silicon layer thereon are employed.

According to the first alternative of the depicted embodiment, the top layer of silicon of the SOI wafer serves as the sacrificial layer 504, and the buried oxide layer serves as the etch stop layer 502.

According to the second alternative of the depicted embodiment, the silicon oxide 504 on the silicon wafer serves as the sacrificial layer 504, and the silicon 502 of the silicon wafer serves as the etch stop layer 502.

In various embodiments, such as the ones according to the first and the second alternative, the etch stop layer 502 provides chemical selectivity with respect to the sacrificial layer 504 against an isotropic etching step.

Fig. 6c and Fig. 6d depict cross sections of intermediate products according to alternative embodiments. The embodiments of Fig. 6c and Fig. 6d are similar to the one of Fig. 6a, Fig. 6b.

However, according to the embodiments of Fig. 6c and Fig. 6d, a bottom electrode 506 is formed over the substrate 500 (and the edge stop layer 502 and the sacrificial layer 504) prior to depositing the layer 114 of insulating material as described in the context of Fig. 6a, Fig. 6b.

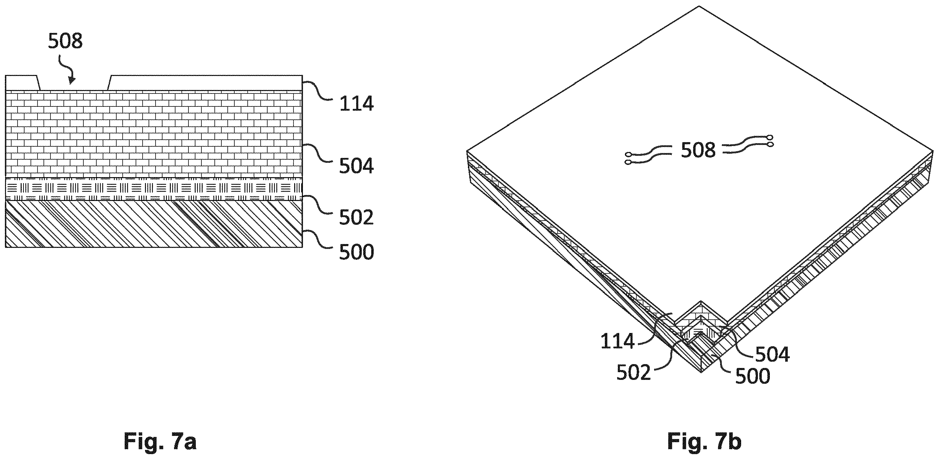

Fig. 7a depicts a cross section of an intermediate product after an etching step (for providing 404 the contact layer 104 separately from the first layer 102a) according to an embodiment. Fig. 7b gives a perspective view of the intermediate product.

In the etching step, openings 508 are etched through the layer 114 of insulating material, extending from its top surface to its bottom surface.

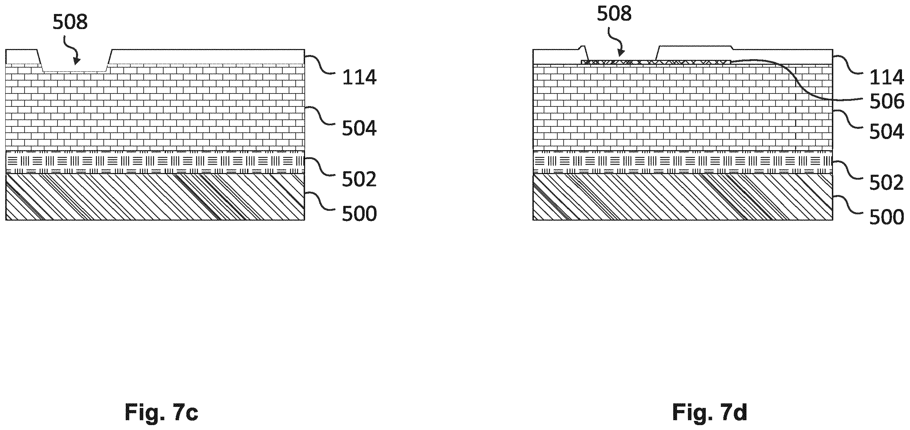

Fig. 7c and Fig. 7d depict cross sections of intermediate products according to alternative embodiments. The embodiments of Fig. 7c and Fig. 7d are similar to the one of Fig. 7a, Fig. 7b.

However, according to the embodiment of Fig. 7c, the etching step is continued to extend the opening 508 into the sacrificial layer 504.

According to the embodiment of Fig. 7d, the bottom electrode 506 serves as an etch stop layer in the etching step.

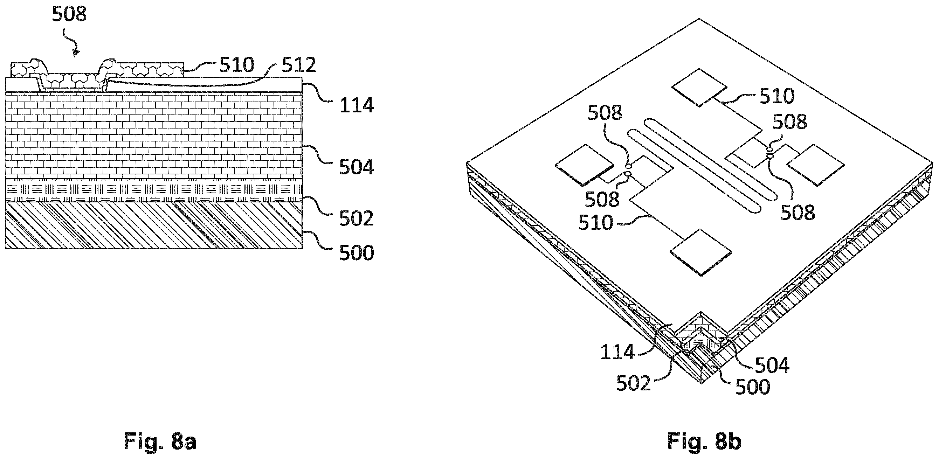

Fig. 8a depicts a cross section of an intermediate product after at least one metallization step (for providing 404 the contact layer 104 separately from the first layer 102a) according to an embodiment. Fig. 8b gives a perspective view of the intermediate product.

In the metallization step, at least one layer of electrically conductive material 510, 512 is deposited over the substrate 500 and at least partially into the openings 508.

The at least one layer of electrically conductive material 510, 512 is also used to produce additional circuitry 510 of the electronics device, such as an optical integrated circuit or the additional electrical components 410a, 410b, 410c.

The metallization step and producing the additional circuitry 510 uses process steps known from the state of the art (e. g. from semiconductor technologies such as CMOS technology) such as etching, lithography, lift-off, printing, and material deposition.

According to the depicted embodiment, two layers of electrically conductive material 510, 512 are deposited. The lower one 512 or both of them 510, 512 in combination may be considered the electrically conductive lines 108, 108a, 108b of the electronics device being fabricated.

According to an alternative, the conductive material 512 improves the adhesion of the electrically conductive line 108a, 108b to the layer material.

According to an alternative, the conductive materials 510, 512 are selected to adapt the work function of the conductive line 108a, 108b to the requirements of the electronics device.

According to an alternative, at least one of the conductive materials 510, 512 is a superconductor material. An optional second conductive material 510, 512 is to become superconducting via proximity effects to the superconductor material when cooling the conductive line 108a, 108b below the critical temperature of the superconductor material.

Optionally, a layer of passivating material such SiNₓ is deposited over the electrically conductive material 510 and/or additional circuitry 510 for an enhanced adhesion to a PDMS stamp in a later lift-off from the second substrate 500.

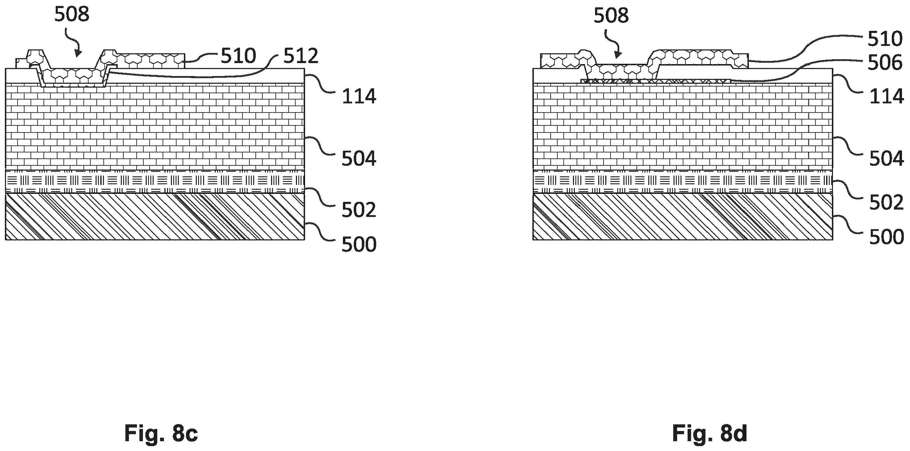

Fig. 8c and Fig. 8d depict a cross sections intermediate products according to alternative embodiments. The embodiments of Fig. 8c and Fig. 8d are similar to the one of Fig. 8a, Fig. 8b.

The intermediate product of Fig. 8c corresponds to the intermediate product of Fig. 7c after performing the metallization step as described in the context of Fig. 8a, Fig. 8b.

The intermediate product of Fig. 8d corresponds to the intermediate product of Fig. 7d after performing the metallization step as described in the context of Fig. 8a, Fig. 8b.

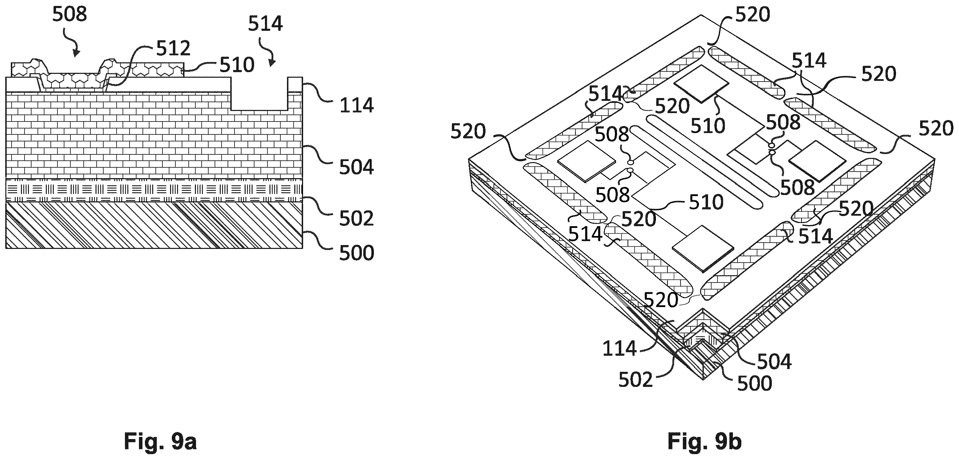

Fig. 9a depicts a cross section of an intermediate product after forming a trench 514 (for providing 404 the contact layer 104 separately from the first layer 102a) according to an embodiment. Fig. 9b gives a perspective view of the intermediate product.

The trench 514 is formed by etching the layer 114 of insulating material and optionally a portion of the sacrificial layer 504 thereunder.

The trench 514 is laterally interrupted by sections serving as anchor points (teathers) 520 to support the layer 114 of insulating material at later process steps.

The trench 514 (ignoring the interruptions) defines regions of dies with lateral extensions selected according to the space requirement of the circuitry 510.

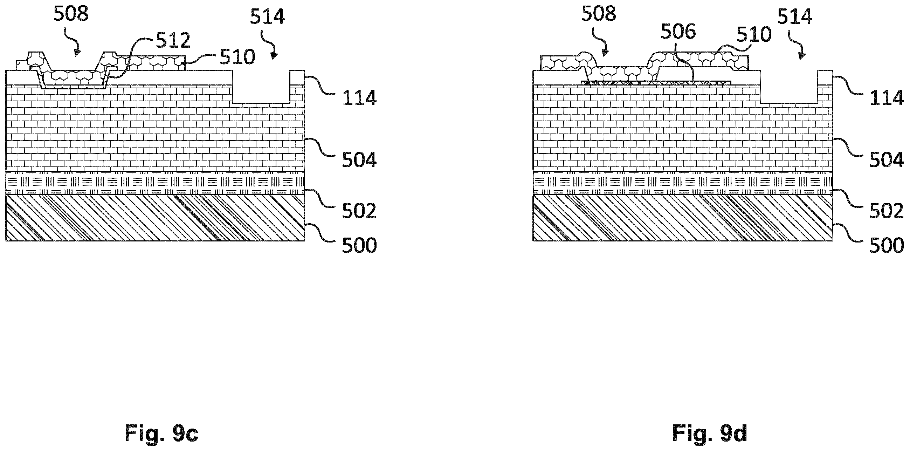

Fig. 9c and Fig. 9d depict a cross sections intermediate products according to alternative embodiments. The embodiments of Fig. gc and Fig. 9d are similar to the one of Fig. 9a, Fig. 9b.

The intermediate product of Fig. gc corresponds to the intermediate product of Fig. 8c after performing the trench 514 formation as described in the context of Fig. 9a, Fig. 9b.

The intermediate product of Fig. 9d corresponds to the intermediate product of Fig. 8d after performing the trench 514 formation as described in the context of Fig. 9a, Fig. 9b.

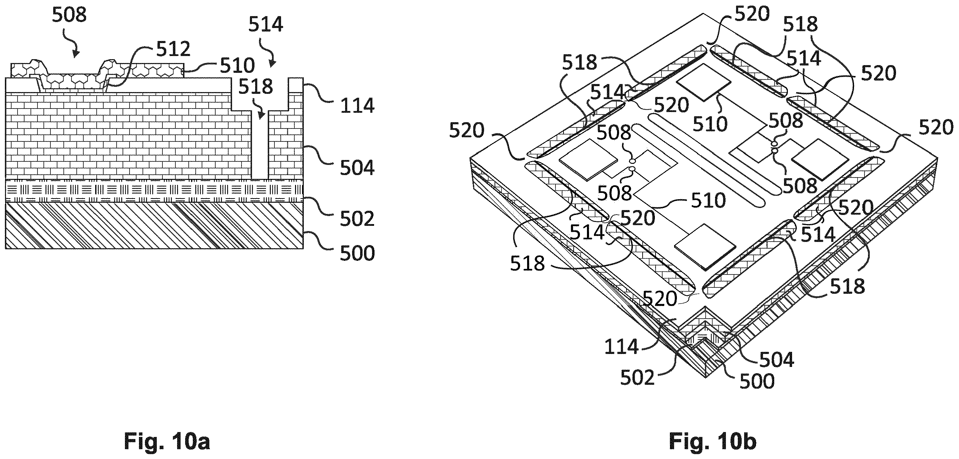

Fig. 10a depicts a cross section of an intermediate product after forming a deeper (than the trench 514) trench 518 (for providing 404 the contact layer 104 separately from the first layer 102a) according to an embodiment. Fig. 10b gives a perspective view of the intermediate product.

The formation of the deeper trench is optional. If applied, it is performed according to the formation of the trench 114 described in the context of Fig. 9a, Fig. 9b.

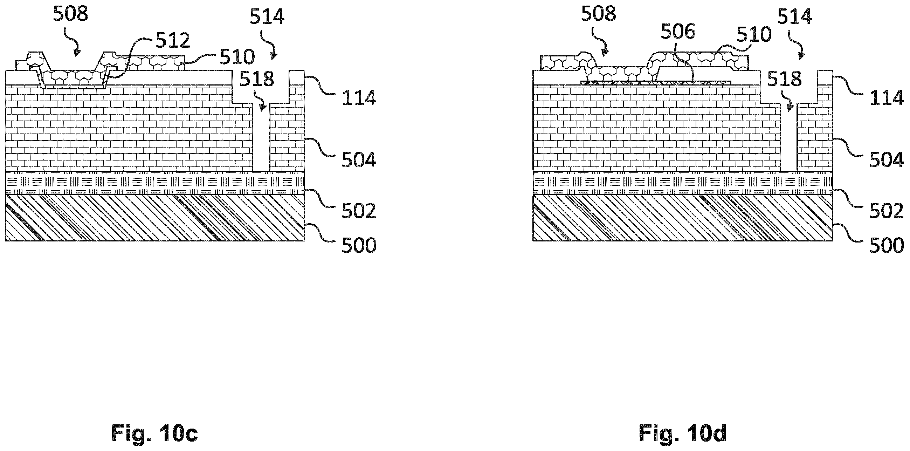

Fig. 10c and Fig. 10d depict a cross sections intermediate products according to alternative embodiments. The embodiments of Fig. 10c and Fig. 10d are similar to the one of Fig. 10a, Fig. 10b.

The intermediate product of Fig. 10c corresponds to the intermediate product of Fig. gc after performing the formation of the deeper trench 518 as described in the context of Fig. 10a, Fig. 10b.

The intermediate product of Fig. 10d corresponds to the intermediate product of Fig. 9d after performing the formation of the deeper trench 518 as described in the context of Fig. 10a, Fig. 10b.

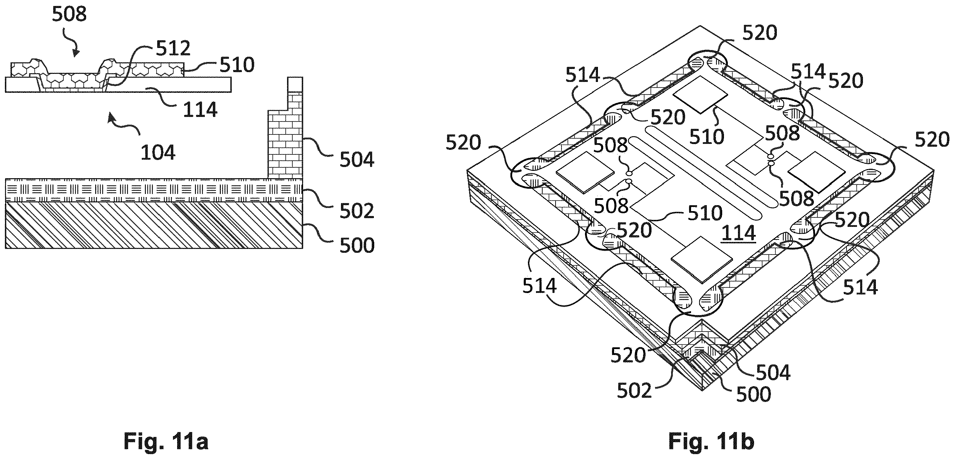

Fig. 11a depicts a cross section of a contact layer 104 separately from the first layer 102a, established by an isotropic etch of the sacrificial layer 504 of Fig. 10a, Fig. 10b. Fig. 11b gives a perspective view of the contact layer 104.

The isotropic etch is performed as a dry etch or a wet etch.

According to embodiments with the silicon sacrificial layer 504, a KOH wet etch or a XeF2 dry etch is applied.

According to embodiments with the silicon oxide sacrificial layer 504, a HF wet etch or a HF dry etch is applied.

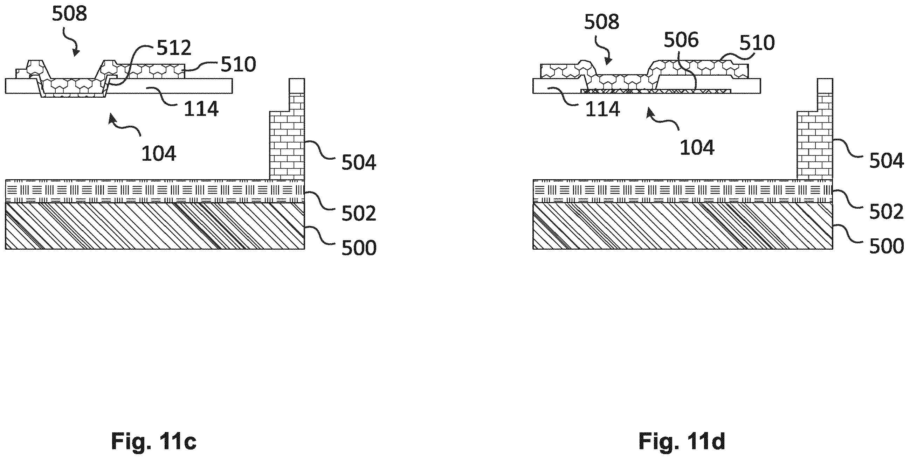

Fig. 11c and Fig. 11d depict contact layers 104 according to alternative embodiments. The embodiments of Fig. 11c and Fig. 11d are similar to the one of Fig. 11a, Fig. 11b.

The contact layer 104 of Fig. 11c corresponds to the intermediate product of Fig. 10c after performing the isotropic etch as described in the context of Fig. 11a, Fig. 11b.

The contact layer 104 of Fig. 11d corresponds to the intermediate product of Fig. 10d after performing the isotropic etch as described in the context of Fig. 11a, Fig. 11b.

Subsequently, the contact layer 104 of any of Fig. 11a, Fig. 11b, Fig. 11e, Fig. 11d is fully removed from the second substrate 500 with a cooled PDMS stamp 412 as described in the context of Fig. 5.

Optionally, the contact layer 104 of any of Fig. 11a, Fig. 11b, Fig. 11c, Fig. 11d is cleaned at its bottom surface (facing away from the PDMS stamp 412), for example a wet and/or dry cleaning step such as etching, ion-milling. If applied, the cleaning step is preferably performed just before arranging the contact layer 104 over the substrate 100, for example with the contact layer 104 on the cooled PDMS stamp 412.

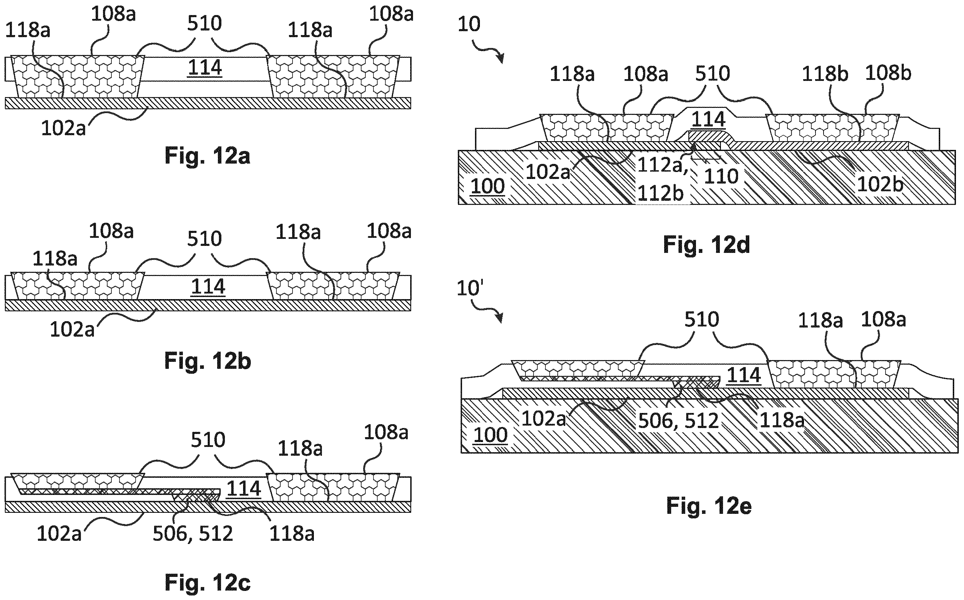

Fig. 12a, Fig. 12b, Fig. 12c, Fig. 12d, and Fig. 12e show examples of electronics devices that have been fabricated using the methods described in the context of Fig. 4 to Fig. 11d.

The electronics devices according to Fig. 12c and Fig. 12e are fabricated by subsequent deposition of two bottom electrodes 506, each as described in the context of Fig. 6c, Fig. 6d. Thereafter, the layer 114 of insulating material is deposited over the bottom electrodes 506 and the method continues as described in the context of Fig. 5 or in the context of Fig. 7a to Fig. 11d.

Fig. 13 illustrates a method for providing a second layer 102b of a second layered material over the first layer 102a of the first layered material arranged over the substrate. The method is optionally applied in the method of Fig. 4 to extend or replace the process steps 400, 402 thereof. In addition, the method of Fig. 13 is combined with the techniques of Fig. 4 to Fig. 11 d to fabricate devices such as the one of Fig. 12d.

According to the intermediate product 600, a first layer 102a of a first layered material is provided over the substrate 100, similar to the provision 400, 402 of the first layer 102a over the substrate 100 described in the context of Fig. 4.

The layered material of the first layer 102a of the intermediate product 600 has a crystallographic orientation 620. The crystallographic orientation 620 corresponds to a direction parallel to the crystallographic plane 216 described in the context of Fig. 2 or parallel to a covalently bound atomic layer 208a, 208b as described in the context of Fig. 2. For example, the crystallographic orientation 620 corresponds to a primitive lattice vector parallel to the crystallographic plane 216 and/or to a direction connecting a row of atoms within a covalently bound atomic layer 208a, 208b.

According to the intermediate product 602, a transfer device 604 in the form of a PDMS stamp 604 is attached to (transferred onto) the first layer 102a and the substrate 100, as similarly described for the attachment of the PDMS stamp 412 of Fig. 5 to the layer 114 of insulating material.

The PDMS stamp 604 is cooled to a temperature below the third temperature described above; the cooling may be performed before or after transferring the PDMS stamp 604 onto the first layer 102a and the substrate 100.

According to the intermediate product 606, the cooled PDMS stamp 604 is removed from the substrate 100 while being cooled. The PDMS cooled below the third temperature provides a strong adhesion. Consequently, when the PDMS stamp 604 is removed from the substrate 100, a portion of the first layer 102a adheres to the PDMS stamp 604. Another portion of the first layer 102a is left behind on the substrate. In other words, the first layer 102a is cleaved.

As described in the context of Fig. 2, the cleaving of the layered material typically takes place along an interface between covalently bound atomic layers 208a, 208b of the layered material, or along a van der Waals gap of the layered material, respectively. Consequently, the surfaces of the layers 102a, 102b of layered material freshly prepared by the cleaving are parallel to covalently bound atomic layers 208a, 208b and/or a crystallographic plane 216 of the layered material.

Referring to the intermediate product 608, the portion of the first layer 102a left behind on the substrate 100 forms a new first layer 102a arranged on the substrate 100. In the following, only this new first layer 102a will be referred to as the first layer 102a.

The portion of the layered material adhering to the PDMS stamp 604 forms the second layer 102b of layered material. According to the depicted embodiment, the second layer 102b is composed of the same material as the first layer 102a. However, a second layer 102b composed of a different layered material can be provided by applying the processes described above in the context of the intermediate products 600, 602, 606 to the different layered material. The portion of the different layered material adhering to the respective PDMS stamp thereafter is then used as the second layer 102b of layered material.

The PDMS stamp 604 with the second layer 102b adhering thereto is then positioned in orientated with respect to the substrate 100 and the first layer 102a.

According to the depicted embodiment, the positioning and orientating involves a rotation 610 around an axis 612 perpendicular to the second layer 102b to rotate (twist) the crystallographic orientation 622 of the second layer 102b with respect to the crystallographic orientation 620 of the first layer 102a.

Referring to the intermediate product 614, the PDMS stamp 604 with the second layer 102b adhering thereto is transferred onto the first layer 102a and the substrate 100 according to the positioning and orientating.

In particular, the PDMS stamp 604 is transferred onto the substrate 100 such that the first layer 102a and the second layer 102b overlap to form the overlap region 110 described above.

Referring to the intermediate product 616, the PDMS stamp 604 is heated to a temperature exceeding the second temperature described above to reduce the adhesion of the PDMS stamp 604.

The PDMS stamp 604 is then removed from the substrate 100.

Due to the reduced adhesion of the PDMS at the elevated temperature exceeding the second temperature, the PDMS stamp 604 releases the first layer 102a and the second layer 102b. The first layer 102a and the second layer 102b are left behind on the substrate 100.

This completes the product 618.

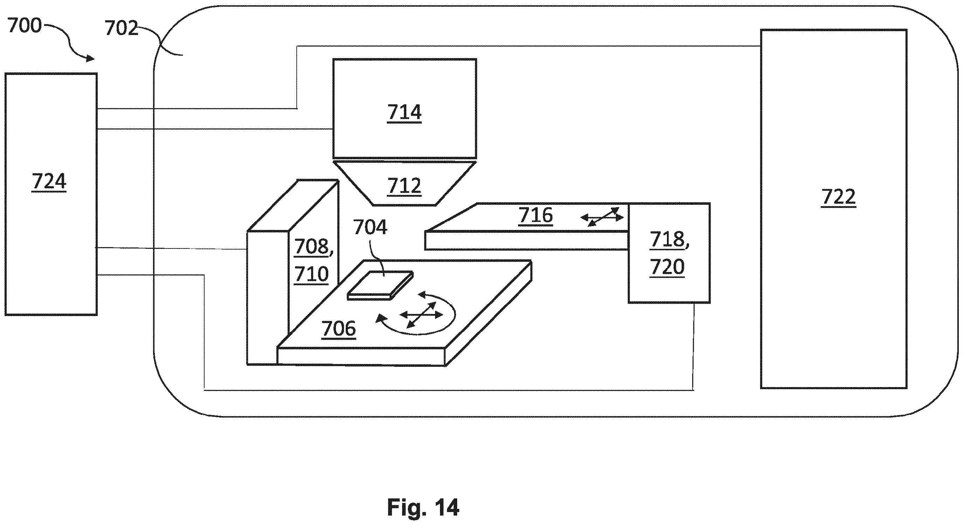

Fig. 14 shows an apparatus 700 according to an embodiment for performing the methods described above in the context of Fig. 4 and Fig. 6.

As illustrated in Fig. 14, the apparatus 700 comprises a containment 702 providing a controlled atmosphere. This is typically an inert gas atmosphere, such as in an inert gas atmosphere comprising nitrogen, argon, or another inert and/or noble gas. However, a controlled atmosphere could also comprise a vacuum. According to an embodiment, the containment 702 is a glove box 702. Within the containment 702, at least one layered material 704, selected to provide the first layer 102a and/or the second layer 102b, is arranged on a stage 706, which provides translational and rotational degrees of freedom, in particular to the layered material 704. To this end, at least one motor 708 is coupled to the stage. In addition, a temperature control system 710 is coupled to the layered material 704 and/or to the stage 706. In particular, the temperature control system 710 comprises a cooling system for providing a sample temperature of the layered material 704, which may be cryogenic and/or below room temperature. The at least one motor 708 and the temperature control system 710 are shown as one integrated system 708, 210 in Fig. 14, but they may also be implemented as two separate systems. An optical technique to identify a position of the layered material 704 is provided by a microscope 712. A camera 714 is connected to the microscope 712. The apparatus 700 further comprises a manipulator 716 with at least one manipulator motor 718, which may be similar to the at least one motor, and a manipulator temperature control system 720, which may be similar to the temperature control system 710. The camera 714 is connected to an electronic control system 224, which may be located outside of the containment 702. The PDMS stamp 412, 604 is connected to the manipulator 716, for example along its bottom side, allowing for positioning and orientating the PDMS stamp 412, 604 with micrometre resolution.

The electronic control system 724 comprises one or more computer components, such as a processor or a memory. The electronic control system 724 is adapted to obtain and optionally to record images associated with the optical technique, for example from the camera 714. The electronic control system 724 is further adapted to obtain and/or record a position of the at least one motor 708 and/or to set a set point position of at least one motor 708. The electronic control system 724 is further adapted to obtain and/or record a manipulator position of the at least one manipulator motor 718 and/or to set a set point manipulator position of at least one manipulator motor 718.

In addition, the electronic control system 724 is adapted to obtain a temperature from the temperature control system 710 and/or to set a set point temperature of the temperature control system 710.

In addition, the electronic control system 724 is adapted to obtain a manipulator temperature from the manipulator temperature control system 720 and/or to set a manipulator set point temperature of the manipulator temperature control system 720. As the PDMS stamp 412, 604 is connected to the manipulator 716, its temperature is controlled via the manipulator temperature (control system 720).

The electronic control system may be adapted to automatically adjust the set point position of the at least one motor 708, the set point temperature of the temperature control system 710, the set point manipulator motor position of the at least one manipulator motor 718, the manipulator set point temperature of the manipulator temperature control system 720, in particular in response to the image obtained from the camera 714, to the position of the at least one motor 708, to the manipulator temperature of the manipulator temperature control system 720, to the manipulator position of the at least one manipulator motor 718, and/or to the manipulator temperature from the manipulator temperature control system 720, respectively.

According to Fig. 14, the at least one motor 708, the temperature control system 710, the microscope 712, the camera 714, the at least one manipulator motor 718, and the manipulator temperature control system 720 are arranged inside the containment 702. However, any of these components may be arranged at least in part outside of the containment 702 and be coupled to its corresponding counterpart inside of the containment 702 by means known from the state-of-the-art. An evaporator system 722 may be arranged in the same containment 702 as the stage 706, or it may be arranged in a separate containment, with means for a transfer between the containment 702 and the separate containment via a controlled atmosphere.

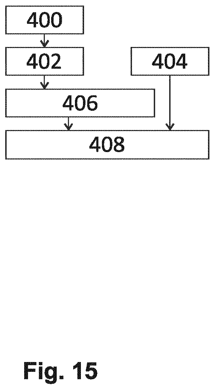

Fig. 15 summarizes process steps for fabricating an electronics device.

At step 400 a substrate is provided.

At step 402 the first layer 102a is provided over the substrate.

At step 404 a contact layer 104 is provided separate from the first layer 102a.

At step 406, the first layer 102a is cooled to a temperature below the first temperature.

At step 408, the contact layer is arranged over the first layer 102a.

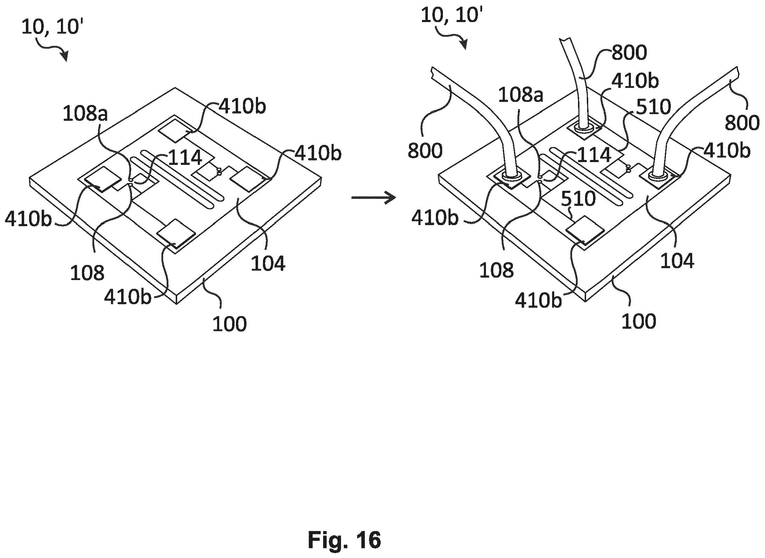

Fig. 16 depicts a subsequent formation of external wiring 800 to the electronics device. Therefore, the external wiring 800 is attached to the bond pads 410b described above.

According to the depicted embodiment, the external wiring 800 is implemented by direct bonding to the bond pads 410b. Alternatively, the external wiring is printed, contact needles are applied, or external wiring is established via physical vapor deposition or CVD while applying a mask such as a stencil mask.

### LIST OF REFERENCE SIGNS

- 100: substrate
- 102a: first layer (of a first layered material)
- 102b: second layer (of a second layered material)
- 104: contact layer
- 106a: top surface of the first layer
- 106b: bottom surface of the second layer
- 108a: first electrically conductive line
- 108b: second electrically conductive line
- 110: overlap region
- 112a: section of the top surface of the first layer
- 112b: section of the bottom surface of the second layer
- 114: electrical insulation element, insulating film
- 118a, 118b: first, second contact
- 200: first gap
- 202: contact region
- 204: distance between first layer and second layer
- 206, 206a, 206b: region of first (second) layered material
- 208a, 208b: covalently bound atomic layer
- 210a, 210b: atoms
- 212a, 212b: nearest neighbor atomic distance
- 214a, 214b: interlayer distance
- 216: crystallographical layer
- 302, 304: second, third gap
- 306: lateral extension of contact layer
- 308: lateral extension of overlap region
- 310: encapsulation
- 400: providing a substrate
- 402: providing a first layer of a first layered material over the substrate
- 404: providing a contact layer separate from the first layer
- 406: cooling the first layer
- 408: arranging the contact layer over the first layer
- 410a, 410b, 410c: additional electric components
- 410a: circuit line
- 410b: contact pad
- 410c: (microwave) antenna
- 412: transfer device, PDMS stamp
- 108: electrically conductive line
- 500: second substrate
- 502: etch stop layer
- 504: sacrificial layer
- 506: bottom electrode layer
- 508: structured layer of insulation material
- 510: metallization layer
- 512: electrical contact layer
- 514: trench
- 518: second trench
- 520: tether
- 602: attaching PDMS stamp to substrate with first layered material
- 604: PDMS stamp
- 606: cleaving first layered material
- 608: alignment and positioning of second layered material arranged on PDMS stamp
- 610: rotation
- 612: axis
- 614: attaching PDMS stamp and second layered material arranged thereon to substrate with first layered material
- 616: removing PDMS stamp
- 618: substrate with first layer of first layered material and second layer of second layered material
- 620, 622: crystallographic orientations of the first, second layered material
- 700: apparatus
- 702: containment
- 704: layered material
- 706: stage
- 708: motor
- 710: temperature control system
- 712: microscope
- 714: camera
- 716: manipulator
- 718: manipulator motor
- 720: manipulator temperature control system
- 722: evaporator system
- 724: electronic control system
- 800: external wiring

## Claims

1. An electronics device (10, 10'), comprising
a substrate (100);
a first layer (102a) of a first layered material arranged over the substrate (100);
a second layer (102b) of a second layered material arranged over the substrate (100);
an overlap region (110); wherein, in the overlap region (110), the second layer (102b) is arranged over the first layer (102a), and a section (112b) of a bottom surface (106b) of the second layer (102b) is parallel to a section (112a) of a top surface (106a) of the first layer (102a);
a contact layer (104) arranged over the first layer (102a) and the second layer (102b), wherein the contact layer (104) comprises:
a plurality of electrically conductive lines comprising a first electrically conductive line (108a) and a second electrically conductive line (108b), wherein the first electrically conductive line (108a) and/or the second electrically conductive line (108b) comprises a superconductor material; and
an electrical insulation element (114) arranged between the electrically conductive lines (108a, 108b) to electrically insulate them from each other;
a first electrical contact (118a) between the first electrically conductive line (108a) and the first layer (102a); and
a second electrical contact (118b) between the second electrically conductive line (108b) and the second layer (102b).

2. The electronics device (10, 10') according to claim 1, comprising a first gap (200) between the contact layer (104) and the first layer (102a) and/or the second layer (102b), and wherein the first gap (200) extends along at least a section of a boundary of the overlap region (110).

3. The electronics device (10, 10') according to claim 1 or 2, wherein the first layered material comprises a second superconductor material, and/or the second layered material comprises a third superconductor material.

4. The electronics device (10, 10') according to any of the preceding claims, wherein in the overlap region (110), the first layer (102a) and the second layer (102b) are in direct physical contact with each other, or spaced apart from each other by no more than 5 nm.

5. The electronics device (10, 10') according to any of the preceding claims, wherein the electrical insulation element (114) comprises silicon nitride and/or at least one metal oxide.

6. The electronics device (10, 10') according to any of the preceding claims,
wherein the first layered material and/or the second layered material comprise covalently bound atomic layers, wherein a covalently bound atomic layer (208a, 208b) of the covalently bound atomic layers comprises:
a nearest-neighbor atomic distance (212a, 212b) between nearest-neighbor atoms of the covalently bound atomic layer (208a, 208b); and
an interlayer distance (214a, 214b) between the covalently bound atomic layer (208a, 208b) and a covalently bound atomic layer (208a, 208a) neighboring the covalently bound atomic layer; and
wherein the interlayer distance (214a, 214b) exceeds the nearest-neighbor atomic distance (212a, 212b).

7. The electronics device (10, 10') according to any of the preceding claims,
wherein a first section of a covalently bound atomic layer (208a, 208b) of the first layered material is parallel to a second section of a covalently bound atomic layer (208a, 208b) of the second layered material; and/or
wherein a crystallographic layer (216) of the first layered material is parallel to a crystallographic layer (216) of the second layered material.

8. The electronics device (10, 10') according to any of the preceding claims, wherein a lateral extension (306) of the contact layer (104) fully covers a lateral extension (308) of the overlap region (110).

9. The electronics device (10, 10') according to any of the preceding claims, which comprises an encapsulation (310) of the overlap region (110), wherein the encapsulation (310) comprises at least a section of the contact layer (104).

10. The electronics device (10, 10') according to any of the preceding claims, wherein crystallographic orientations (620, 622) of the first layered material and the second layered material differ in the overlap region (110).

11. The electronics device (10, 10') according to claim 10, comprising:
a first crystallographic orientation (620) parallel to a first crystallographic layer (216) of the first layered material in the overlap region (110), and
a second crystallographic orientation (622) parallel to a second crystallographic layer (216) of the second layered material in the overlap region (110);
wherein the differing crystallographic orientations (620, 622) refer to the first crystallographic orientation (620) and the second crystallographic orientation (622).

12. The electronics device (10, 10') according to any of the preceding claims, wherein a layer of an elastomer (412) is arranged over the contact layer (104).

13. The electronics device (10, 10') according to any of the preceding claims, further comprising a contact region (202) in which the first layer (102a) is arranged over the substrate (100), wherein the second layer (102b) does not extend into the contact region (202); and wherein the first electrical contact is arranged in the contact region (202).

14. A method for fabricating an electronics device (10, 10'), comprising
providing (400) a substrate (100);
providing (402) a first layer (102a) of a first layered material over the substrate (100);
providing (404) a contact layer (104) separate from the first layer (102a), wherein the contact layer (104) comprises:
a plurality of electrically conductive lines comprising a first electrically conductive line (108a); and
an electrical insulation element (114) arranged between the electrically conductive lines to electrically insulate them from each other;
cooling (406) the first layer (102a) to a temperature below a first temperature of o°C; and
arranging (408) the contact layer (104) over the first layer (102a), such that
a first electrical contact (118a) is formed between the first electrically conductive line (108a) and the first layer (102a).

15. The method according to claim 14, which further comprises:
keeping the first layer (102a) at a temperature below the first temperature while arranging the contact layer (104) over the first layer (102a).

## Amended claims

### Amended claims in accordance with Rule 137(2) EPC.

1. An electronics device (10, 10'), comprising
a substrate (100);
a first layer (102a) of a first anisotropic layered material arranged over the substrate (100);
a second layer (102b) of a second anisotropic layered material arranged over the substrate (100);
wherein the first and/or the second layered material comprises a first superconductor material or a transition metal chalcogenide and/or a transition metal oxide;
an overlap region (110); wherein, in the overlap region (110), the second layer (102b) is arranged over the first layer (102a), and a section (112b) of a bottom surface (106b) of the second layer (102b) is parallel to a section (112a) of a top surface (106a) of the first layer (102a);
a contact layer (104) arranged over the first layer (102a) and the second layer (102b), wherein the contact layer (104) comprises:
a plurality of electrically conductive lines comprising a first electrically conductive line (108a) and a second electrically conductive line (108b), wherein the first electrically conductive line (108a) and/or the second electrically conductive line (108b) comprises a second superconductor material; and
an electrical insulation element (114) arranged between the electrically conductive lines (108a, 108b) to electrically insulate them from each other;
a first electrical contact (118a) between the first electrically conductive line (108a) and the first layer (102a); and
a second electrical contact (118b) between the second electrically conductive line (108b) and the second layer (102b).

2. The electronics device (10, 10') according to claim 1, comprising a first gap (200) between the contact layer (104) and the first layer (102a) and/or the second layer (102b), and wherein the first gap (200) extends along at least a section of a boundary of the overlap region (110).

3. The electronics device (10, 10') according to claim 1 or 2, wherein the first anisotropic layered material comprises the first superconductor material, and/or the second anisotropic layered material comprises a third superconductor material.

4. The electronics device (10, 10') according to any of the preceding claims, wherein in the overlap region (110), the first layer (102a) and the second layer (102b) are in direct physical contact with each other, or spaced apart from each other by no more than 5 nm.

5. The electronics device (10, 10') according to any of the preceding claims, wherein the electrical insulation element (114) comprises silicon nitride and/or at least one metal oxide.

6. The electronics device (10, 10') according to any of the preceding claims,
wherein the first anisotropic layered material and/or the second anisotropic layered material comprise covalently bound atomic layers, wherein a covalently bound atomic layer (208a, 208b) of the covalently bound atomic layers comprises:
a nearest-neighbor atomic distance (212a, 212b) between nearest-neighbor atoms of the covalently bound atomic layer (208a, 208b); and
an interlayer distance (214a, 214b) between the covalently bound atomic layer (208a, 208b) and a covalently bound atomic layer (208a, 208a) neighboring the covalently bound atomic layer; and
wherein the interlayer distance (214a, 214b) exceeds the nearest-neighbor atomic distance (212a, 212b).

7. The electronics device (10, 10') according to any of the preceding claims,
wherein a first section of a covalently bound atomic layer (208a, 208b) of the first anisotropic layered material is parallel to a second section of a covalently bound atomic layer (208a, 208b) of the second anisotropic layered material; and/or
wherein a crystallographic layer (216) of the first anisotropic layered material is parallel to a crystallographic layer (216) of the second anisotropic layered material.

8. The electronics device (10, 10') according to any of the preceding claims, wherein a lateral extension (306) of the contact layer (104) fully covers a lateral extension (308) of the overlap region (110).

9. The electronics device (10, 10') according to any of the preceding claims, which comprises an encapsulation (310) of the overlap region (110), wherein the encapsulation (310) comprises at least a section of the contact layer (104).

10. The electronics device (10, 10') according to any of the preceding claims, wherein crystallographic orientations (620, 622) of the first anisotropic layered material and the second anisotropic layered material differ in the overlap region (110).

11. The electronics device (10, 10') according to claim 10, comprising:
a first crystallographic orientation (620) parallel to a first crystallographic layer (216) of the first anisotropic layered material in the overlap region (110), and
a second crystallographic orientation (622) parallel to a second crystallographic layer (216) of the second anisotropic layered material in the overlap region (110);
wherein the differing crystallographic orientations (620, 622) refer to the first crystallographic orientation (620) and the second crystallographic orientation (622).

12. The electronics device (10, 10') according to any of the preceding claims, wherein a layer of an elastomer (412) is arranged over the contact layer (104).

13. The electronics device (10, 10') according to any of the preceding claims, further comprising a contact region (202) in which the first layer (102a) is arranged over the substrate (100), wherein the second layer (102b) does not extend into the contact region (202); and wherein the first electrical contact is arranged in the contact region (202).

14. A method for fabricating an electronics device (10, 10'), comprising
providing (400) a substrate (100);
providing (402) a first layer (102a) of a first anisotropic layered material over the substrate (100);
providing (404) a contact layer (104) separate from the first layer (102a), wherein the contact layer (104) comprises:
a plurality of electrically conductive lines comprising a first electrically conductive line (108a); and
an electrical insulation element (114) arranged between the electrically conductive lines to electrically insulate them from each other;
cooling (406) the first layer (102a) to a temperature below a first temperature of 0°C; and
arranging (408) the contact layer (104) over the first layer (102a), such that a first electrical contact (118a) is formed between the first electrically conductive line (108a) and the first layer (102a), wherein arranging the contact layer (104) over the first layer (102a) comprises:
providing a transfer device (412) with the contact layer (104) arranged thereon; wherein the transfer device (412) comprises an elastomer;
heating the transfer device (412) to release the contact layer (104) therefrom and over the first layer (102a); and
keeping the first layer (102a) at a temperature below the first temperature while arranging the contact layer (104) over the first layer (102a).

15. The method according to claim 14, wherein the transfer device (412) is adapted to provide a weak adhesion when its temperature is above a second temperature and to provide a strong adhesion when its temperature is below a third temperature, wherein the second temperature is higher than the third temperature, and wherein heating the transfer device (412) to release the contact layer (104) therefrom and over the first layer comprises:
heating the transfer device to a temperature between the second temperature and the first temperature.
